# EUROPEAN PATENT APPLICATION

(11) **EP 4 658 046 A1**
(43) Date of publication of application: **03.12.2025**
(21) Application number: 24813990.9
(22) Date of filing: 17.04.2024
(51) Int. Cl.: H10K 59/131

(54) **DISPLAY PANEL AND DISPLAY DEVICE**

(30) Priority: 30.05.2023 CN 202310627900
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: SHI, Kunyan, Beijing 100176 (CN); SONG, Erlong, Beijing 100176 (CN); WU, Dongjie, Beijing 100176 (CN); SUN, Huaping, Beijing 100176 (CN); ZHANG, Kai, Beijing 100176 (CN); XU, Peng, Beijing 100176 (CN); ZHANG, Qi, Beijing 100176 (CN)
(74) Representative: Hoffmann Eitle
(86) International application number: PCT/CN2024/088409
(87) International publication number: WO 2024/244784

(57) **Abstract**

Disclosed is a display panel. The display panel comprises a display area, and the display area comprises a middle area and two edge areas. The display panel comprises a base substrate and a driving circuit layer. The driving circuit layer comprises a plurality of pixel circuit units, a plurality of data write signal lines, a plurality of data leads, and a shielding layer. The plurality of data write signal lines are located in the display area; each data lead comprises a first lead segment and a second lead segment; one end of the first lead segment is electrically connected to one data write signal line located in the edge area, and the other end of the first lead segment is electrically connected to one end of the second lead segment; and the second lead segment is located in the middle area. The orthographic projection of the second lead segment on the base substrate at least partially overlaps with the orthographic projection of a first electrode of at least one driving transistor on the base substrate. The shielding layer is configured to have a constant voltage signal. The shielding layer comprises at least one first shielding pattern, and the first shielding pattern is located between the first electrode of the driving transistor and the second lead segment.

## Description

This application claims priority to Chinese Patent Application No. 202310627900.8, filed on May 30, 2023, which is incorporated herein by reference in its entirety.

### TECHNICAL FIELD

The present disclosure relates to the field of display technologies, and in particular, to a display panel and a display device.

### BACKGROUND

OLED (Organic Light Emitting Diode) display devices have become one of the most competitive and promising display devices due to their advantages such as self-luminescence, fast response speed, high brightness, full viewing angle, and flexible display.

### SUMMARY

In an aspect, a display panel is provided. The display panel includes a display area. The display area includes a middle area and two edge areas, and the middle area is located between the two edge areas along a first direction. The display panel includes a base substrate and a driving circuit layer located on a side of the base substrate. The driving circuit layer includes: a plurality of pixel circuit units, a plurality of data writing signal lines, a plurality of data leads and a shielding layer. The plurality of pixel circuit units are arranged in a plurality of rows and a plurality of columns in the display area. A pixel circuit unit includes at least one pixel driving sub-circuit, and a pixel driving sub-circuit includes a driving transistor. The plurality of data writing signal lines are located in the display area, and the plurality of data writing signal lines are arranged along the first direction and extend along a second direction; the second direction intersects the first direction; and a data writing signal line is connected to a column of pixel driving sub-circuits. A data lead includes a first lead segment and a second lead segment; an end of the first lead segment is electrically connected to one data writing signal line located in an edge area, and another end of the first lead segment is electrically connected to an end of the second lead segment. The first lead segment extends along the first direction, and the second lead segment extends along the second direction. The second lead segment is located in the middle area. An orthogonal projection of the second lead segment on the base substrate at least partially overlaps with an orthogonal projection of a first electrode of at least one driving transistor on the base substrate. The shielding layer is configured to have a constant voltage signal. The shielding layer includes at least one first shielding pattern; a first shielding pattern is located between the first electrode of the driving transistor and the second lead segment; and an orthogonal projection of the first shielding pattern on the base substrate, the orthogonal projection of the first electrode of the driving transistor on the base substrate, and the orthogonal projection of the second lead segment on the base substrate overlap.

In some embodiments, the orthogonal projection of the first shielding pattern on the base substrate covers the orthogonal projection of the first electrode of the driving transistor on the base substrate.

In some embodiments, along the first direction, the second lead segment and the first shielding pattern are located on a same side of a gate of the driving transistor.

In some embodiments, the pixel driving sub-circuit further includes a data writing transistor and a first reset transistor. A first electrode of the data writing transistor is electrically connected to one data writing signal line, and a second electrode of the data writing transistor is electrically connected to a first electrode of the driving transistor. A first electrode of the first reset transistor is electrically connected to a gate of the driving transistor. Along the second direction, in the pixel driving sub-circuit in the pixel circuit unit, the first reset transistor is located on a side of the data writing transistor away from the driving transistor, and at least a portion of the first lead segment extending through the same pixel circuit unit is located on a side of the first reset transistor away from the data writing transistor.

In some embodiments, along the first direction, the first lead segment includes a main body and an avoidance portion, and the avoidance portion protrudes relative to the main body toward a side away from the driving transistor. The avoidance portion is located on the side of the first reset transistor away from the data writing transistor.

In some embodiments, the pixel circuit unit includes two pixel driving sub-circuits arranged along the first direction, and the two pixel driving sub-circuits are a first pixel driving sub-circuit and a second pixel driving sub-circuit, respectively. A second lead segment corresponding to the first pixel driving sub-circuit is adjacent to a second lead segment corresponding to the second pixel driving sub-circuit. A first shielding pattern in the first pixel driving sub-circuit is arranged adjacent to a first shielding pattern in the second pixel driving sub-circuit.

In some embodiments, the first shielding pattern in the first pixel driving sub-circuit is electrically connected to the first shielding pattern in the second pixel driving sub-circuit, and the first shielding pattern in the first pixel driving sub-circuit is arranged in a same layer as the first shielding pattern in the second pixel driving sub-circuit.

In some embodiments, the first pixel driving sub-circuit and the second pixel driving sub-circuit are symmetrical along the first direction.

In some embodiments, an orthogonal projection of the first lead segment on the base substrate partially overlaps with an orthogonal projection of the data writing signal line on the base substrate. The shielding layer further includes at least one second shielding pattern, and a second shielding pattern is located between the first lead segment and the data writing signal line; and an orthogonal projection of the second shielding pattern on the base substrate, the orthogonal projection of the first lead segment on the base substrate, and the orthogonal projection of the data writing signal line on the base substrate overlap.

In some embodiments, the driving circuit layer further includes a first semiconductor layer, a first gate metal layer, a second gate metal layer, a first wiring metal layer, and a second wiring metal layer that are stacked on the base substrate. A first electrode of the driving transistor is located in the first semiconductor layer. The first lead segment is located in the first wiring metal layer, and the second lead segment is located in the second wiring metal layer. The first shielding pattern is located in the second gate metal layer and/or the first wiring metal layer.

In some embodiments, the driving circuit layer further includes a first semiconductor layer, a first gate metal layer, a second gate metal layer, a first wiring metal layer, a second wiring metal layer, and a third wiring metal layer that are stacked on the base substrate. A first electrode of the driving transistor is located in the first semiconductor layer. The first lead segment is located in the first wiring metal layer, and the second lead segment is located in the third wiring metal layer. The first shielding pattern is located in at least one of the second gate metal layer, the first wiring metal layer, and the second wiring metal layer.

In some embodiments, the driving circuit layer further includes a third gate metal layer located between the second gate metal layer and the first wiring metal layer. At least a portion of the first shielding pattern is located in the third gate metal layer.

In some embodiments, the pixel circuit unit further includes a first power signal line located in the second wiring metal layer, and the first power signal line is configured to provide a constant voltage power signal to the pixel driving circuit. The first power signal line is electrically connected to the shielding layer.

In some embodiments, the pixel driving sub-circuit further includes a storage capacitor; a first electrode plate of the storage capacitor is electrically connected to a gate of the driving transistor, and a second electrode plate of the storage capacitor is electrically connected to the first power signal line. The first electrode plate of the storage capacitor is located in the first gate metal layer, and the first electrode plate of the storage capacitor is further used as the gate of the driving transistor. The second electrode plate of the storage capacitor is located in the second gate metal layer.

In some embodiments, the second electrode plate of the storage capacitor includes a first sub-portion. Along a direction perpendicular to the base substrate, the first sub-portion, the first electrode of the driving transistor and the second lead segment overlap, and the first sub-portion is further used as the first shielding pattern.

In some embodiments, the first wiring metal layer further includes a first connecting portion, the first connecting portion is used to electrically connect the second electrode of the storage capacitor and the first power signal line, and the first connecting portion is further used as the first shielding pattern.

In some embodiments, the pixel driving sub-circuit further includes a first light-emitting control transistor; a first electrode of the first light-emitting control transistor is electrically connected to the first electrode of the driving transistor, and a second electrode of the first light-emitting control transistor is electrically connected to the first power signal line. The first wiring metal layer further includes a first transfer portion; the first transfer portion is used to electrically connect the second electrode of the first light-emitting control transistor and the first power signal line, and the first transfer portion is further used as the first shielding pattern.

In some embodiments, the display panel further includes a bonding area. The bonding area is located on a side of the display area. The bonding area includes a connecting lead, and another end of the data lead is electrically connected to the connecting lead.

In another aspect, a display device is provided. The display device includes the display panel in any one of the above embodiments.

### BRIEF DESCRIPTION OF THE DRAWINGS

In order to describe technical solutions in the present disclosure more clearly, the accompanying drawings to be used in some embodiments of the present disclosure will be introduced briefly. Obviously, the accompanying drawings to be described below are merely drawings of some embodiments of the present disclosure, and a person of ordinary skill in the art can obtain other drawings according to these accompanying drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a structural diagram of a display panel, in accordance with some embodiments;
FIG. 2 is a structural diagram of a display panel, in accordance with some embodiments;
FIG. 3 is a section view of a display panel, in accordance with some embodiments;
FIG. 4 is a structural diagram of a display panel, in accordance with some other embodiments;
FIG. 5 is a structural diagram showing a film layer of a pixel driving unit, in accordance with some embodiments;
FIG. 6 is a circuit diagram of a pixel driving sub-circuit, in accordance with some embodiments;
FIG. 7 is a circuit diagram of a pixel driving sub-circuit, in accordance with some other embodiments;
FIG. 8 is a timing diagram of a pixel driving sub-circuit, in accordance with some embodiments;
FIG. 9 is a diagram showing a film layer of the first semiconductor layer in FIG. 5;
FIG. 10 is a diagram showing a film layer of the first gate metal layer in FIG. 5;
FIG. 11 is a diagram showing film layers of the first semiconductor layer and the first gate metal layer in FIG. 5;
FIG. 12 is a diagram showing a film layer of the first wiring metal layer in FIG. 5;
FIG. 13 is a diagram showing a film layer of the second wiring metal layer in FIG. 5;
FIG. 14 is a diagram showing film layers of the first semiconductor layer, the first gate metal layer, the first wiring metal layer, and the second wiring metal layer in FIG. 5;
FIG. 15 is a structural diagram showing a film layer of a pixel driving unit, in accordance with some other embodiments;
FIG. 16 is a structural diagram showing a film layer of a pixel driving unit, in accordance with yet some other embodiments;
FIG. 17 is a diagram showing a film layer of the first semiconductor layer in FIG. 15;
FIG. 18 is a diagram showing a film layer of the first gate metal layer in FIG. 15;
FIG. 19 is a diagram showing film layers of the first semiconductor layer and the first gate metal layer in FIG. 15;
FIG. 20 is a diagram showing a film layer of the second gate metal layer in FIG. 15;
FIG. 21 is a diagram showing a film layer of the first wiring metal layer in FIG. 15;
FIG. 22 is a diagram showing a film layer of the second wiring metal layer in FIG. 15;
FIG. 23 is a diagram showing of a second gate metal layer of a pixel driving sub-circuit, in accordance with some embodiments;
FIG. 24 is a diagram showing of a second gate metal layer of a pixel driving sub-circuit, in accordance with some other embodiments;
FIG. 25 is a structural diagram showing a film layer of a pixel driving unit, in accordance with yet some other embodiments;
FIG. 26 is a diagram showing a film layer of the second semiconductor layer in FIG. 15;
FIG. 27 is a diagram showing a film layer of the third gate metal layer in FIG. 15; and
FIG. 28 is a diagram showing film layers of the second gate metal layer, the second semiconductor layer, and the third gate metal layer in FIG. 15.

### DETAILED DESCRIPTION

The technical solutions in some embodiments of the present disclosure will be described clearly and completely with reference to the accompanying drawings; obviously, the described embodiments are merely some but not all embodiments of the present disclosure. All other embodiments obtained by a person having ordinary skill in the art based on the embodiments of the present disclosure shall be included in the protection scope of the present disclosure.

Unless the context requires otherwise, throughout the description and claims, the term "comprise" and other forms thereof such as the third-person singular form "comprises" and the present participle form "comprising" are construed as an open and inclusive meaning, i.e., "including, but not limited to". In the description of the specification, terms such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics described may be included in any one or more embodiments or examples in any suitable manner.

The terms "first" and "second" are used for descriptive purposes only, and are not to be construed as indicating or implying a relative importance or implicitly indicating a number of indicated technical features. Thus, a feature defined with "first" or "second" may explicitly or implicitly include one or more of the features. In the description of the embodiments of the present disclosure, the term "a plurality of" / "the plurality of" means two or more unless otherwise specified.

Some embodiments may be described using the terms "coupled," "connected" and their derivatives. For example, the term "connected" may represent a fixed connection, or a detachable connection, or a one-piece connection; alternatively, the term "connected" may represent a direct connection, or an indirect connection through an intermediate medium. For example, the term "coupled" indicates that two or more components are in direct physical or electrical contact. The term "coupled" or "communicatively coupled" may also mean that two or more components are not in direct contact with each other but still cooperate or interact with each other. The embodiments disclosed herein are not necessarily limited to the content herein.

The phrase "at least one of A, B, and C" has the same meaning as the phrase "at least one of A, B, or C", both including the following combinations of A, B, and C: only A, only B, only C, a combination of A and B, a combination of A and C, a combination of B and C, and a combination of A, B, and C.

The phrase "A and/or B" includes following three combinations: only A, only B, and a combination of A and B.

As used herein, the term "if" is, optionally, construed as "when" or "in a case where" or "in response to determining that" or "in response to detecting," depending on the context. Similarly, depending on the context, the phrase "if it is determined that" or "if [a stated condition or event] is detected" is optionally construed as "in a case where it is determined that" or "in response to determining that" or "in a case where [the stated condition or event] is detected" or "in response to detecting [the stated condition or event]."

The use of the phrase "applicable to" or "configured to" herein means an open and inclusive expression, which does not exclude devices that are applicable to or configured to perform additional tasks or steps.

In addition, the use of the phrase "based on" or "according to" is meant to be open and inclusive, since a process, step, calculation or other action that is "based on" or "according to" one or more of the stated conditions or values may, in practice, be based on or according to additional conditions or values exceeding those stated.

The term such as "about", "substantially" or "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

The term such as "parallel", "perpendicular" or "equal" as used herein includes a stated case and a case similar to the stated case within an acceptable range of deviation determined by a person of ordinary skill in the art, considering measurement in question and errors associated with measurement of a particular quantity (i.e., limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; and the term "equal" includes absolute equality and approximate equality, and an acceptable range of deviation of the approximate equality may be, for example, a difference between two equals being less than or equal to 5% of either of the two equals.

It will be understood that, in a case where a layer or an element is referred to as being on another layer or a substrate, it may be that the layer or the element is directly on the another layer or the base substrate, or there may be a middle layer between the layer or the element and the another layer or the base substrate.

Exemplary embodiments are described herein with reference to sectional views and/or plan views as idealized exemplary drawings. In the drawings, thicknesses of layers and sizes of regions are enlarged for clarity. Variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a feature being curved. Therefore, the regions shown in the accompanying drawings are schematic in nature, and their shapes are not intended to show actual shapes of the regions in a device, and are not intended to limit the scope of the exemplary embodiments.

For all transistors used in the circuit provided in the embodiments of the present disclosure, a first electrode of each transistor is one of a source and a drain, and a second electrode of the transistor is the other of the source and the drain. Since the source and the drain of the transistor may be symmetrical in structure, the source and the drain of the transistor may be indistinguishable in structure. That is, there may be no difference in structure between the first electrode and the second electrode of the transistor in the embodiments of the present disclosure.

For example, in a case where the transistor is a P-type transistor, the first electrode of the transistor is a source, and the second electrode thereof is a drain.

For example, in a case where the transistor is an N-type transistor, the first electrode of the transistor is a drain, and the second electrode thereof is a source.

In the circuit provided in the embodiments of the present disclosure, the first node, the second node and the like do not represent actual components, but rather represent junctions of related electrical connections in a circuit diagram. That is, these nodes are nodes equivalent to the junctions of the related couplings in the circuit diagram.

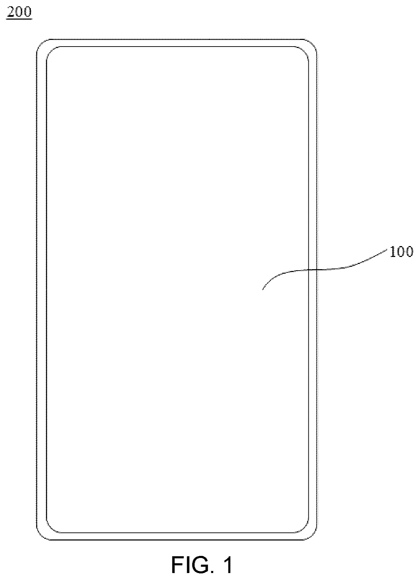

FIG. 1 is a structural diagram of a display device, in accordance with some embodiments. As shown in FIG. 1, some embodiments of the present disclosure provide a display device 200, and the display device 200 includes a display panel 100.

For example, the display device 200 further includes a frame, and other electronic components.

For example, the display device 200 may be an electroluminescent display device or a photoluminescence display device. In a case where the display device is the electroluminescent display device, the electroluminescent display device may be an organic light-emitting diode (OLED) display device or a quantum dot light emitting diode (QLED) display device. In a case where the display device is the photoluminescent display device, the photoluminescent display device may be a quantum dot photoluminescent display device.

For example, the display device 200 may be any device that displays images whether in motion (e.g., videos) or stationary (e.g., static images), and whether textual or graphical. More specifically, it is expected that the display device in the embodiments may be implemented in or associated with a plurality of electronic devices. The plurality of electronic devices may include (but is not limit to), for example, mobile telephones, wireless devices, personal data assistants (PDA), hand-held or portable computers, GPS receivers/navigators, cameras, MP4 video players, video cameras, game consoles, watches, clocks, calculators, TV monitors, flat panel displays, computer monitors, car displays (such as odometer displays, etc.), navigators, cockpit controllers and/or displays, camera view displays (such as rear view camera displays in vehicles), electronic photos, electronic billboards or indicators, projectors, building structures, packagings and aesthetic structures (such as a display for an image of a piece of jewelry) etc.

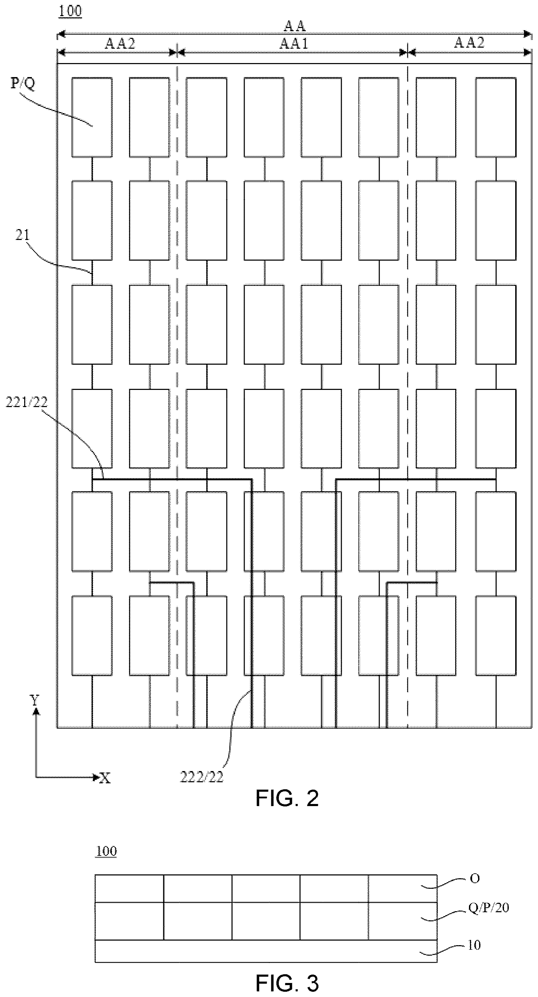

FIG. 2 is a structural diagram of a display panel, in accordance with some embodiments, and FIG. 3 is a section view of a display panel, in accordance with some embodiments.

Referring to FIGS. 2 and 3, some embodiments of the present disclosure provide a display panel 100. The display panel 100 includes a display area (also referred to as an active area, or an active display area) AA. The display area AA includes a middle area AA1 and two edge areas AA2. Along a first direction X, the middle area AA1 is located between the two edge areas AA2.

For example, along the first direction X, widths of the two edge areas AA2 of the display area AA are the same or approximately the same.

The display panel 100 includes a base substrate 10 and a driving circuit layer 20 located on a side of the base substrate 10.

In some examples, the base substrate 10 may be a flexible base. For example, a material of the base substrate 10 may be an organic material. For example, the material of the base substrate 10 may be any one of polyimide (PI), polycarbonate (PC) or polyvinyl chloride (PVC).

In some other examples, the above-mentioned base substrate 10 may be a rigid substrate. For example, the rigid substrate may be a glass substrate or a polymethyl methacrylate (PMMA) substrate.

The driving circuit layer 20 includes a plurality of pixel circuit units P, a plurality of data writing signal lines 21 and a plurality of data leads 22.

The plurality of pixel circuit units P are arranged in a plurality of rows and a plurality of columns in the display area AA. A single pixel circuit unit P includes at least one pixel driving sub-circuit Q.

In some examples, the single pixel circuit unit P may include one pixel driving sub-circuit Q. It can be understood that, in some other examples, the single pixel circuit unit P may include multiple pixel driving sub-circuits Q. For example, the single pixel circuit unit P may include two pixel driving sub-circuits Q. FIG. 2 illustrates an example in which the single pixel circuit unit P may include one pixel driving sub-circuit Q.

For convenience of description, the plurality of pixel circuit units P are described in the present disclosure by taking an example in which the plurality of pixel circuit units P are arranged in a matrix. In this case, since the single pixel circuit unit P includes at least one pixel driving sub-circuit Q, a plurality of pixel driving sub-circuits Q in the display panel 100 are also described by taking an example in which the plurality of pixel driving sub-circuits Q are arranged in a matrix.

In this case, the pixel driving sub-circuits P arranged in a line along the first direction X are referred to as a row of pixel driving sub-circuits, and the pixel driving sub-circuits P arranged in a line along the second direction Y are referred to as a column of pixel driving sub-circuits.

In some embodiments, with continued reference to FIG. 3, the display panel 100 may further include a plurality of light-emitting units O located on a side of the driving circuit layer 20 away from the base substrate 10, and the plurality of pixel driving sub-circuits Q are electrically connected to the plurality of light-emitting units O.

In some examples, the above-mentioned plurality of pixel driving sub-circuits Q and the plurality of light-emitting units O may be electrically connected in one-to-one correspondence. In some other examples, a single pixel driving sub-circuit Q may be coupled to multiple light-emitting units O, or multiple pixel driving sub-circuits Q may be coupled to one light-emitting unit O.

Hereinafter, the structure of the display panel 100 will be described in the present disclosure by taking an example in which a single pixel driving sub-circuit Q is coupled to one light-emitting unit O.

In the display panel 100, the pixel driving sub-circuit Q may be adjusted based on a plurality of different types of signal lines to generate a driving signal. Each light-emitting unit O may emit light due to the driving action of the driving signal generated by a corresponding pixel driving sub-circuit Q, and the light emitted by the plurality of light-emitting units O cooperates with each other, so that the display panel 100 may implement the display function.

In some examples, the light-emitting unit O includes an anode layer, a light-emitting layer, and a cathode layer that are sequentially stacked. In some examples, the cathode layer and the light-emitting layer are further provided with an electron transport layer therebetween, and the anode layer and the light-emitting layer are further provided with a hole transport layer therebetween. For example, the above light-emitting unit O may be an OLED light-emitting unit, which is not limited thereto. The embodiments of the present disclosure do not limit the types of the light-emitting units. That is, the light-emitting unit O may be any other light-emitting unit (e.g., a light-emitting unit that emits light through discharge), as long as they can emit light and the display panel 100 may display images.

In some examples, the display area AA includes a plurality of sub-pixel areas, and one of the plurality of sub-pixel areas includes a pixel driving sub-circuit Q and a light-emitting unit O electrically connected to the pixel driving sub-circuit Q. Based on this, the display panel 100 may display a predetermined image in the display area AA through the light emitted by the light-emitting units O in the plurality of sub-pixel areas. For example, the plurality of sub-pixel areas may include sub-pixel areas that are of different light-emitting colors.

For example, the plurality of sub-pixel areas include a first sub-pixel area, a second sub-pixel area, and a third sub-pixel area. The first sub-pixel area, the second sub-pixel area, and the third sub-pixel area respectively emit light of three primary colors. For example, the first sub-pixel area may emit red light, the second sub-pixel area may emit green light, and the third sub-pixel area may emit blue light.

The plurality of different types of signal lines include the data writing signal line 21. The data writing signal line 21 is configured to provide a data writing signal to the pixel driving sub-circuit Q. The data writing signal may be a pulse signal. That is, the data writing signal is a constantly changing, non-constant signal.

The plurality of data writing signal lines 21 are located in the driving circuit layer 20, are arranged along the first direction X, and extend along the second direction Y. The plurality of data writing signal lines 21 are located in the display area AA. A single data writing signal line 21 is connected to a column of pixel driving sub-circuits Q. The first direction X intersects with the second direction Y.

In some examples, the first direction X is perpendicular to the second direction Y. It can be understood that in some other examples, the first direction X intersects with the second direction Y to form a first included angle, and the first included angle may be an obtuse angle or an acute angle.

A part of the plurality of data writing signal lines 21 are located in an edge area AA2, another part of the plurality of data writing signal lines 21 are located in another edge area AA2, and yet another part of the plurality of data writing signal lines 21 are located in the middle area AA1.

In some examples, the numbers of the data writing signal lines 21 in the two edge areas AA2 may be the same. In some other examples, the numbers of data writing signal lines 21 in the two edge areas AA2 may be different.

In some examples, the number of data writing signal lines 21 in an edge area AA2 may be the same as the number of data writing signal lines 21 in the middle area AA1. In some other examples, the number of data writing signal lines 21 in an edge area AA2 may be different from the number of data writing signal lines 21 in the middle area AA1.

The display panel 100 may adopt a Fanout In AA (FIAA) technology to arrange the data leads 22 in the display area AA, which may conducive to achieving a narrow frame of the display panel 100.

The data lead 22 includes a first lead segment 221 and a second lead segment 222. The second lead segment 222 extends along the second direction Y, and the second lead segment 222 is located in the middle area AA1. Furthermore, the first lead segment 221 extends along the first direction X. One end of the first lead segment 221 is located in the edge area AA2, and another end of the first lead segment 221 is located in the middle area AA1.

Based on this, the one end of the first lead segment 221 may be electrically connected to a data writing signal line 21 located in the edge area AA2, and the another end of the first lead segment 221 may be electrically connected to one end of the second lead segment 222 located in the middle area AA1. In this way, it may implement that the data writing signal line 21 in the edge area AA2 is switched to the middle area AA1, which is conducive to implementing the narrow frame of the display panel 100.

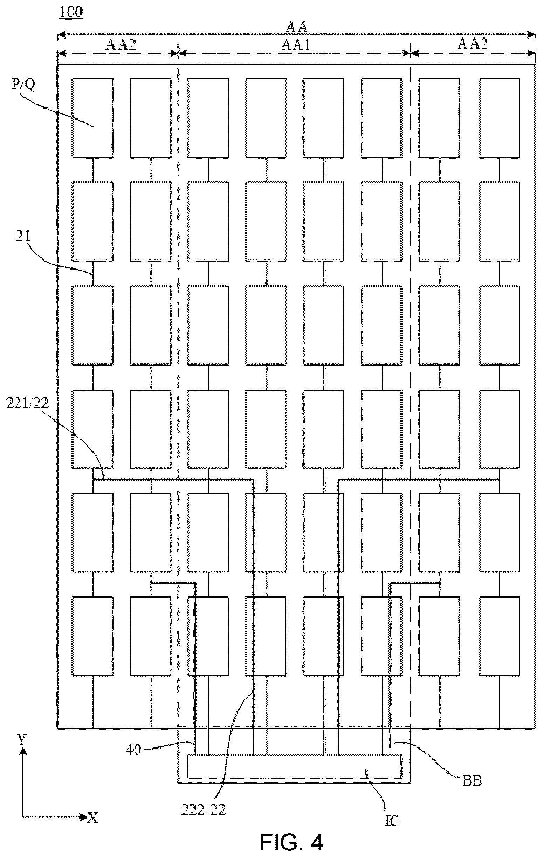

FIG. 4 is a structural diagram of a display panel, in accordance with some other embodiments.

In some embodiments, referring to FIG. 4, the display panel 100 further includes a bonding area BB. The bonding area BB is located on a side of the display area AA. The bonding area BB includes a connecting lead 40. Another end of the data lead 22 is electrically connected to the connecting lead 40.

In some examples, the bonding area BB may further include a driving chip integrated circuit (IC).

One end of the connecting lead 40 in the bonding area BB is electrically connected to the driving chip IC, another end of the connecting lead 40 is electrically connected to the another end of the data lead 22, and one end of the data lead 22 is electrically connected to the data writing signal line 21. Based on this, the data writing signal provided by the driving chip IC may be input to the data writing signal line 21 through the connecting lead 40 and the data lead 22 in sequence, and the data writing signal line 21 may transmit the data writing signal to the pixel driving sub-circuit Q.

In some examples, the data writing signal line 21 located in the middle area AA1 may be electrically connected to the connecting lead 40 in the bonding area BB through the data lead 22. It can be understood that, in some other embodiments, the data writing signal line 21 located in the middle area AA1 may be directly electrically connected to the connecting lead 40 in the bonding area BB. FIG. 4 illustrates an example in which the data writing signal line 21 in the middle area AA1 may be directly electrically connected to the connecting lead 40 in the bonding area BB.

Based on this, the signal lines (the data leads 22 electrically connected to the data writing signal lines 21 in the edge area AA2 and the data writing signal lines 21 in the middle area AA1) that need to be electrically connected to the bonding area BB may be concentrated in the display area AA at a position corresponding to the driving chip IC, which is conducive to achieving the narrow frame.

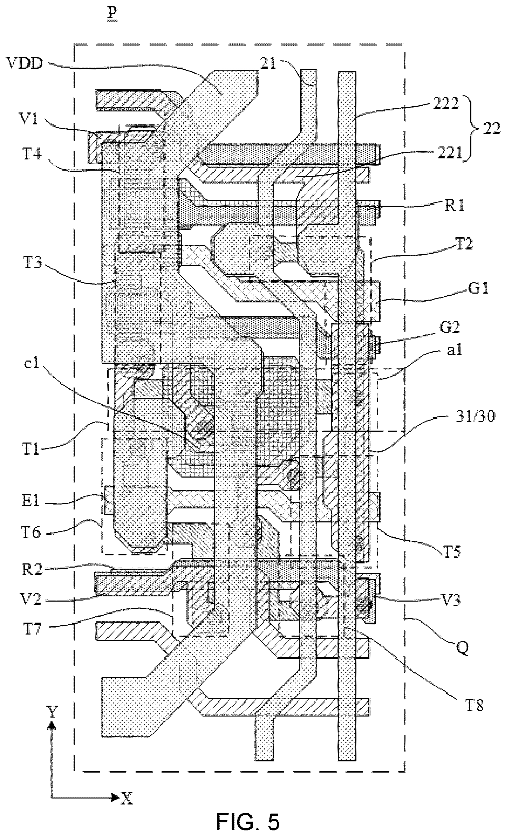

However, it is found through research by inventors of the present disclosure that, returning to FIG. 2 or FIG. 5, in a case where the data lead 22 is disposed in the display area AA, an orthogonal projection of the data lead 22 on the base substrate 10 will overlap with an orthogonal projection of the pixel driving sub-circuit Q on the base substrate 10.

Based on this, parasitic capacitance will be generated between the data lead 22 and the pixel driving sub-circuit Q. Based on the capacitive coupling effect, in a case where the data lead 22 transmits the data writing signal to the data writing signal line 21, and the input data writing signal jumps, it will cause a potential of the pixel driving sub-circuit Q to be affected, thereby affecting the driving signal output by the pixel driving sub-circuit Q to the light-emitting unit O, and then causing the brightness of the light-emitting unit O to affect the brightness uniformity of the display panel 100.

FIG. 5 is a structural diagram showing a film layer of a pixel driving unit, in accordance with some embodiments. FIG. 5 illustrates an example in which a pixel driving unit P includes a pixel driving sub-circuit Q. That is, FIG. 5 may also be understood as a structural diagram showing a film layer of a pixel driving sub-circuit, in accordance with some embodiments.

As for the display panel 100 provided by some embodiments of the present disclosure, with continued reference to FIG. 5, the driving circuit layer 20 in the display panel 100 further includes a shielding layer 30, and the shielding layer 30 is configured to have a constant voltage signal. The shielding layer 30 includes at least one first shielding pattern 31. And, the pixel driving sub-circuit Q includes a driving transistor T1.

In a case where an orthogonal projection of the second lead segment 222 on the base substrate 10 at least partially overlaps with an orthogonal projection of a first electrode a1 of at least one driving transistor T1 on the base substrate 10, the first shielding pattern 31 is disposed between the first electrode a1 of the driving transistor T1 and the second lead segment 222, and the first shielding pattern 31 is configured to have the constant voltage signal.

For example, the first shielding pattern 31 is disposed in a film layer located between a film layer where the second lead segment 222 is located and a film layer where the first electrode a1 of the driving transistor T1 is located, and an orthogonal projection of the first shielding pattern 31 on the base substrate 10, the orthogonal projection of the second lead segment 222 on the base substrate 10, and the orthogonal projection of the first electrode a1 of at least one driving transistor T1 on the base substrate 10 are overlapped.

Based on this, the first shielding pattern 31 may be used to isolate the second lead segment 222 and the first electrode a1 of the driving transistor T1. Furthermore, since the first shielding pattern 31 is configured to have the constant voltage signal, the first shielding pattern 31 may be utilized to improve the influence of the data writing signal transmitted by the second lead segment 222 on the potential of the first electrode a1 of the driving transistor T1 when the data writing signal jumps, which is conducive to improving the stability of the driving transistor T1 in the pixel driving sub-circuit Q, and improving the brightness uniformity of the display panel 100.

It will be noted that FIG. 5 above takes the example that the first electrode a1 of the driving transistor T1 is located at a right side of the driving transistor T1. It can be understood that, in some other examples, the left side of the driving transistor T1 may also be used as the first electrode a1 of the driving transistor T1.

In summary, the display panel 100 provided in some embodiments of the present disclosure may adopt FIAA technology to arrange the data leads 22 in the display area AA of the display panel 100, so as to implement the narrow frame of the display panel 100. Furthermore, the driving circuit layer 20 in the display panel 100 further includes the shielding layer 30. The first shielding pattern 31 is configured to have the constant voltage signal, and the first shielding pattern 31 is located between the first electrode a1 of the driving transistor T1 and the second lead segment 222. The first shielding pattern 31 in the shielding layer 30 is used to isolate the first electrode a1 of the driving transistor T1 and the second lead segment 222 in the data lead 22. The first shielding pattern 31 may improve the influence of the data writing signal transmitted by the second lead segment 222 to the data writing signal line 21 on the potential of the first electrode a1 of the driving transistor T1 when the data writing signal jumps, which is conducive to improving the stability of the driving transistor T1 in the pixel driving sub-circuit Q and improving the brightness uniformity of the display panel 100. That is, the display panel 100 provided in some embodiments of the present disclosure may ensure the uniformity of the display panel 100 while achieving the narrow frame of the display panel 100.

The first electrode a1 of the driving transistor T1 may be a source of the driving transistor T1. Alternatively, the first electrode a1 of the driving transistor T1 may be a drain of the driving transistor T1. Hereinafter, the description will be made by taking an example that the first electrode a1 of the driving transistor T1 may be the source electrode of the driving transistor T1.

In some embodiments, with continued reference to FIG. 5, in a case where the first shielding pattern 31 is disposed between the second lead segment 222 of the data lead 22 and the first electrode a1 of the driving transistor T1, the orthogonal projection of the first shielding pattern 31 on the base substrate 10 is set to at least partially overlap with the orthogonal projection of the first electrode a1 of the driving transistor T1 on the base substrate 10.

Based on this, the first shielding pattern 31 and the first electrode a1 of the driving transistor T1 will also generate parasitic capacitance. Based on the effect of capacitive coupling, the first shielding pattern 31 with a constant voltage signal may be conducive to stabilizing the potential of the first electrode a1 of the driving transistor T1, which is conducive to improving the stability of the driving transistor T1 in the pixel driving sub-circuit Q and improving the brightness uniformity of the display panel 100.

In some examples, with continued reference to FIG. 5, the orthogonal projection of the first shielding pattern 31 on the base substrate 10 is set to at least partially overlap with the orthogonal projection of the first electrode a1 of the driving transistor T1 on the base substrate 10. For example, the orthogonal projection of the first shielding pattern 31 on the base substrate 10 may be set to at least partially overlap with the orthogonal projection of the first electrode a1 of the driving transistor T1 on the base substrate 10 in an overlapping area. The overlapping area refers to an overlapping area between the orthogonal projection of the second lead segment 222 on the base substrate 10 and the orthogonal projection of the first electrode a1 of the at least one driving transistor T1 on the base substrate 10.

Based on this, the display panel 100 may use the first shielding pattern 31 in the shielding layer 30 to isolate the first electrode a1 of the driving transistor T1 and the second lead segment 222 of the data lead 22. The first shielding pattern 31 may improve the influence of the data writing signal transmitted by the second lead segment 222 to the data writing signal line 21 on the potential of the first electrode a1 of the driving transistor T1 when the data writing signal jumps, which is conducive to improving the stability of the driving transistor T1 of the pixel driving sub-circuit Q and improving the brightness uniformity of the display panel 100.

In some other examples, with continued reference to FIG. 5, on the basis of arranging the first shielding pattern 31 between the second lead segment 222 of the data lead 22 and the first electrode a1 of the driving transistor T1, the orthogonal projection of the first shielding pattern 31 on the base substrate 10 may further be set to cover the orthogonal projection of the first electrode a1 of the driving transistor T1 on the base substrate 10.

The orthogonal projection of the first shielding pattern 31 on the base substrate 10 covering the orthogonal projection of the first electrode a1 of the driving transistor T1 on the base substrate 10, includes the following two situations.

In the first situation, the orthogonal projection of the first shielding pattern 31 on the base substrate 10 overlaps with the orthogonal projection of the first electrode a1 of the driving transistor T1 on the base substrate 10. That is, a size of the first shielding pattern 31 is substantially equal to a size of the first electrode a1 of the driving transistor T1, so that the first shielding pattern 31 may effectively shield the first electrode a1 of the driving transistor T1, and prevent the influence of the data writing signal transmitted by the second lead segment 222 to the data writing signal line 21 on the potential of the first electrode a1 of the driving transistor T1 when the data writing signal jumps, which is conducive to improving the stability of the driving transistor T1 in the pixel driving sub-circuit Q and improving the brightness uniformity of the display panel 100.

In the second situation, an outer edge of the orthogonal projection of the first shielding pattern 31 on the base substrate 10 surrounds an outer edge of the orthogonal projection of the first electrode a1 of the driving transistor T1 on the base substrate 10. That is, the size of the first shielding pattern 31 is greater than the size of the first electrode a1 of the driving transistor T1, so that the first shielding pattern 31 may shield the first electrode a1 of the driving transistor T1 to a greater extent, thereby preventing the influence of the data writing signal transmitted by the second lead segment 222 to the data writing signal line 21 on the potential of the first electrode a1 of the driving transistor T1 when the data writing signal jumps, which is conducive to improving the stability of the driving transistor T1 of the pixel driving sub-circuit Q and improving the brightness uniformity of the display panel 100. However, the embodiments of the present disclosure are not limited thereto.

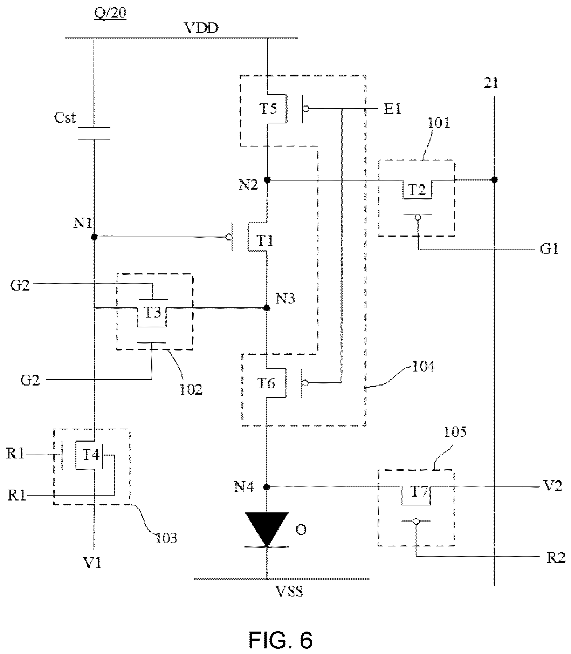

FIG. 6 is a circuit diagram of a pixel driving sub-circuit, in accordance with some embodiments.

In some embodiments, with reference to FIGS. 5 and 6, the driving circuit layer 20 in the display panel 100 includes a plurality of metal layers. The plurality of metal layers are provided with the pixel driving sub-circuits Q and the plurality of different types of signal lines therein. In addition to the data writing signal line 21 and the data lead 22, the plurality of different types of signal lines may further include a first power signal line VDD, a first scanning signal line G1, a second scanning signal line G2, a first reset signal line R1, a second reset signal line R2, a first initialization signal line V1, a second initialization signal line V2, and an enable signal line E1, etc. The above-mentioned multiple signal lines may be electrically connected to the pixel driving sub-circuit Q, so as to provide signals for the pixel driving sub-circuit Q that is required by the pixel driving sub-circuit Q.

The plurality of metal layers include a first semiconductor layer POLY1, a first gate metal layer Gate1, a first wiring metal layer SD1, and a second wiring metal layer SD2 that are stacked on the base substrate 10. The above-mentioned multiple signal lines are respectively located in the above-mentioned metal layers, and the arrangement will be described in detail below.

The structure of the pixel driving sub-circuit Q varies, which may be set according to actual needs. For example, the pixel driving sub-circuit Q may include a structure such as "2T1C", "6T1C", "7T1C", "6T2C", "7T2C" or "8T1C". Here, "T" represents a thin film transistor, a number before "T" represents the number of thin film transistors, "C" represents a storage capacitor, and a number before "C" represents the number of storage capacitors.

That is, the pixel driving sub-circuit Q may include a plurality of transistors, and the above embodiments only describes that the pixel driving sub-circuit Q includes the driving transistor T1.

A gate c1 of the driving transistor T1 is electrically connected to a first node N1, the first electrode a1 of the driving transistor T1 is electrically connected to a second node N2, and a second electrode b1 of the driving transistor T1 is electrically connected to a third node N3.

The driving transistor T1 is configured to transmit a voltage from the second node N2 to the third node N3 under control of a voltage at the first node N1.

In addition, the pixel driving sub-circuit Q may further include other transistors. The following will be described by considering the pixel driving sub-circuit of "7T1C" as an example.

The pixel driving sub-circuit Q further includes a writing sub-circuit 101, a compensation sub-circuit 102, a first reset sub-circuit 103, a light-emitting control sub-circuit 104, and a second reset sub-circuit 105.

The writing sub-circuit 101 is coupled to the first scanning signal line G1, the data writing signal line 21 and the second node N2. The writing sub-circuit 101 is configured to transmit a data signal received at the data writing signal line 21 to the second node under control of the first scanning signal received from the first scanning signal line G1 during a writing phase.

In some examples, the writing sub-circuit 101 includes a data writing transistor T2. A gate c2 of the data writing transistor T2 is electrically connected to the first scanning signal line G1, a first electrode a2 of the data writing transistor T2 is electrically connected to the data writing signal line 21, and a second electrode b2 of the data writing transistor T2 is electrically connected to the second node N2.

The compensation sub-circuit 102 is coupled to the second scanning signal line G2, the third node N3, and the first node N1. The compensation sub-circuit 102 is configured to transmit a voltage of the third node N3 to the first node N1 under control of a second scanning signal received from the second scanning signal line G2 during the writing phase.

In some examples, the compensation sub-circuit 102 includes a compensation transistor T3. A gate c3 of the compensation transistor T3 is electrically connected to the second scanning signal line G2, a first electrode a3 of the compensation transistor T3 is electrically connected to the third node N3, and a second electrode b3 of the compensation transistor T3 is electrically connected to the first node N1.

The first reset sub-circuit 103 is configured to transmit a first initialization signal received at the first initialization signal line V1 to the first node N1 under control of a first reset signal received from the first reset signal line R1, and reset the first node N1 during an initialization phase, which is conducive to ensuring the stability of the voltage of the first node N1.

In some examples, the first reset sub-circuit 103 includes a first reset transistor T4. A gate c4 of the first reset transistor T4 is electrically connected to the first reset signal line R1, a first electrode a4 of the first reset transistor T4 is electrically connected to the first node N1, and a second electrode b4 of the first reset transistor T4 is electrically connected to the first initialization signal line V1.

The light-emitting control sub-circuit 104 is coupled to the enable signal line E1, the first power signal line VDD, the second node N2, and a fourth node N4. The light-emitting control sub-circuit 104 is configured to cooperate with the driving transistor T1 under control of the enable signal from the enable signal line E1 to transmit a driving signal to the fourth node N4. The fourth node N4 is electrically connected to the light-emitting unit O. That is, the light-emitting control sub-circuit 104 is configured to cooperate with the driving transistor T1 to transmit the driving signal to the light-emitting unit O under the control of the enable signal from the enable signal line E1.

In some examples, the light-emitting control sub-circuit 104 includes a first light-emitting control transistor T5 and a second light-emitting control transistor T6. A gate c5 of the first light-emitting control transistor T5 is electrically connected to the enable signal line E1, a first electrode a5 of the first light-emitting control transistor T5 is electrically connected to the second node N2, and a second electrode b5 of the first light-emitting control transistor T5 is electrically connected to the first power signal line VDD. A gate c6 of the second light-emitting control transistor T6 is electrically connected to the enable signal line E1, a first electrode a6 of the second light-emitting control transistor T6 is electrically connected to the third node N3, and a second electrode b6 of the second light-emitting control transistor T6 is electrically connected to the fourth node N4.

The second reset sub-circuit 105 is electrically connected to the second reset signal line R2, the second initialization signal line V2 and the fourth node N4. The second reset sub-circuit 105 is configured to transmit a second initialization signal from the second initialization signal line V2 to the fourth node N4 under control of a second reset signal received from the second reset signal line R2, and reset the fourth node N4 during the initialization phase.

The fourth node N4 is electrically connected to the light-emitting unit O. Resetting the fourth node N4 is equivalent to resetting the anode of the light-emitting unit O by using the signal, thereby improving the stability of the light-emitting unit O.

In some examples, the second reset sub-circuit 105 includes a second reset transistor T7. A gate c7 of the second reset transistor T7 is electrically connected to the second reset signal line R2, a first electrode a7 of the second reset transistor T7 is electrically connected to the second initialization signal line V2, and a second electrode b7 of the second reset transistor T7 is electrically connected to the fourth node N4.

In some embodiments, with continued reference to FIGS. 5 and 6, the compensation transistor T3 and the first reset transistor T4 may be oxide thin film transistors. For example, the compensation transistor T3 and the first reset transistor T4 may be indium gallium zinc oxide (IGZO) thin film transistors.

Such arrangement may be conducive to reducing the risk of electric leakage of the compensation transistor T3 and the first reset transistor T4, and more conducive to ensuring the stability of the voltage of the first node N1, that is, ensuring the stability of the gate c1 of the driving transistor T1.

In some examples, the compensation transistor T3 and the first reset transistor T4 may be N-type transistors.

In some embodiments, with continued reference to FIGS. 5 and 6, the driving transistor T1, the data writing transistor T2, the first light-emitting control transistor T5, the second light-emitting control transistor T6, and the second reset transistor T7 may be low temperature polysilicon oxide (LTPO) thin film transistors.

In some examples, the driving transistor T1, the data writing transistor T2, the first light-emitting control transistor T5, the second light-emitting control transistor T6, and the second reset transistor T7 may be P-type transistors.

In addition, the pixel driving sub-circuit Q further includes a storage capacitor Cst. A first electrode S1 of the storage capacitor Cst is electrically connected to the first node N1, and a second electrode S2 of the storage capacitor Cst is electrically connected to the first power signal line VDD.

It will be noted that the N-type transistor is turned on when receiving a high voltage signal at the gate, and the P-type transistor is turned on when receiving a low voltage signal at the gate. It will be noted that, the "high voltage signal" and "low voltage signal" mentioned above are common terms. Generally, the turn-on condition of the N-type transistor is that a gate-source voltage difference is greater than a threshold voltage thereof. That is, the gate voltage of the N-type transistor is greater than a sum of the source voltage thereof and the threshold voltage thereof, and the threshold voltage of the N-type transistor is a positive value. In this case, the gate voltage signal that turns on the N-type transistor is referred to as a high voltage signal. The turn-on condition of the P-type transistor is that an absolute value of a gate-source voltage difference is greater than a threshold voltage thereof, and the threshold voltage of the P-type transistor is a negative value. That is, the gate voltage of the P-type transistor is less than a sum of the source voltage thereof and the threshold voltage thereof. In this case, the gate voltage signal that turns on the P-type transistor is referred to as a low voltage signal. The voltage of the "high voltage signal" is greater than the voltage of the "low voltage signal".

It will be noted that each pixel driving sub-circuit Q in the display panel 100 includes a plurality of thin film transistors (TFT). The use of TFT driving technology may improve display speed, contrast, brightness, and resolution. However, TFT has a hysteresis effect. The hysteresis effect of TFT is an uncertainty exhibited by the electrical characteristics of TFT under a certain bias voltage. That is, the current flowing through the TFT is not only related to the current bias voltage, but also related to a state of the TFT at a previous moment. The hysteresis effect of TFT is related to the gate dielectric, the semiconductor material and the interface state trap therebetween. During the light-emitting phase, the hysteresis effect of TFT will cause a current drop trend within a frame, which is perceived by the human eye as a flickering phenomenon, thereby affecting the display quality of the display panel 100.

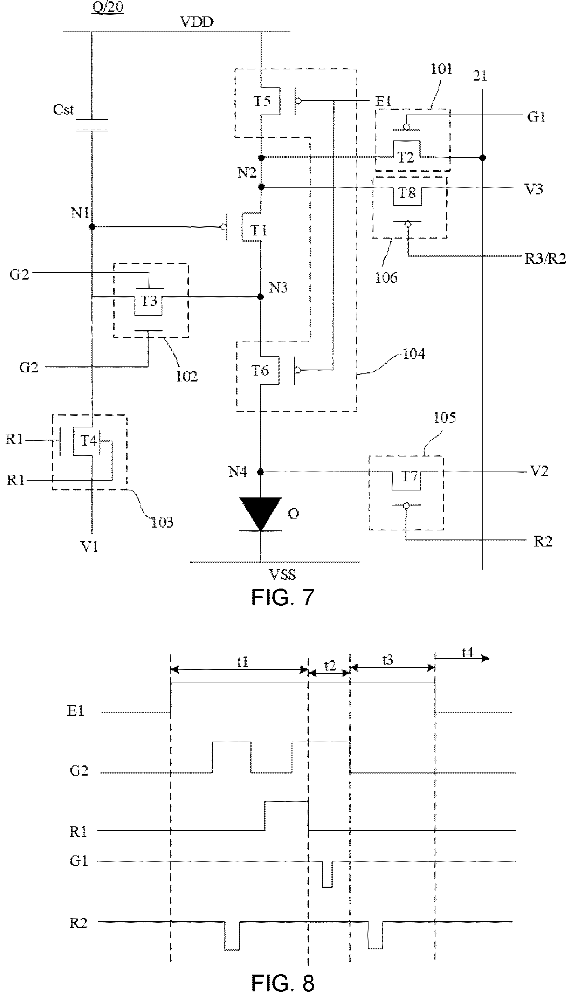

FIG. 7 is a circuit diagram of a pixel driving sub-circuit, in accordance with some other embodiments.

Furthermore, in some embodiments, referring to FIG. 7, the pixel driving sub-circuit provided in the embodiments is introduced by taking the "8T1C" pixel driving sub-circuit as an example, and a difference between the "8T1C" pixel driving sub-circuit and the pixel driving sub-circuit Q shown in FIG. 6 is that the pixel driving sub-circuit shown in FIG. 6 further includes a third reset sub-circuit 106.

The third reset sub-circuit 106 is coupled to the third reset signal line R3, the third initialization signal line V3 and the second node. The third sub-circuit is configured to transmit a third initialization signal from the third initialization signal line V3 to the second node N2 under control of a third reset signal from the third reset signal line R3, and initialize the second node N2. In this way, the initial state of the driving transistor TD may be fixed before the writing phase, thereby facilitating the stable state of the driving transistor TD during the writing phase, and greatly improving the hysteresis effect of the driving transistor TD.

The third reset sub-circuit 106 further includes a third reset transistor T8. A gate c8 of the third reset transistor T8 is electrically connected to the third reset signal line R3, a first electrode a8 of the third reset transistor T8 is electrically connected to the third initialization signal line V3, and a second electrode b8 of the third reset transistor T8 is electrically connected to the second node N2.

In some examples, the third reset transistor T8 may be a low temperature polysilicon oxide (LTPO) thin film transistor.

In some examples, the third reset transistor T8 may be a p-type transistor.

In some embodiments, the third reset signal line R3 and the second reset signal line R2 may respond to a same signal line. Alternatively, it may also be understood that the second reset signal line R2 is further used as the third reset signal line R3. Hereinafter, the description will be made by taking an example that the second reset signal line R2 is further used as the third reset signal line R3.

In some embodiments, the third initialization signal transmitted by the third initialization signal line V3 may be a high voltage signal. Furthermore, the high voltage signal may be used to reset the second node N2, which is equivalent to resetting the first electrode a1 of the driving transistor T1, so that the initial state of the driving transistor T1 before the data writing phase t2 is fixed, which facilitates the driving transistor T1 to be in a stable state during the data writing phase t2, thereby greatly improving the hysteresis effect of the driving transistor T1.

In some examples, the first power signal line VDD may be further used as the third initialization signal line V3, based on which the arrangement of the transistors in the pixel driving sub-circuit Q and the signal lines electrically connected thereto may be simplified. However, the present disclosure are not limited thereto.

FIG. 8 is a timing diagram of a pixel driving sub-circuit, in accordance with some embodiments.

In some embodiments, with reference to FIGS. 7 and 8, the driving process of the pixel driving sub-circuit Q of "8T1C" shown in FIG. 7 is that one frame period includes an initialization phase t1, a data writing phase t2, an adjustment phase t3 and a light-emitting phase t4.

In the initialization phase t1, the enable signal transmitted by the enable signal line E1 is a high voltage signal. In this case, the first light-emitting control transistor T5 and the second light-emitting control transistor T6 are both in a turn-off state. The first scanning signal transmitted by the first scanning signal line G1 is a high voltage signal, and in this case, the data writing transistor T2 is in the turned-off state.

The first reset signal transmitted by the first reset signal line R1 includes a high voltage signal. In this case, the first reset transistor T4 is turned on, and the first initialization signal transmitted by the first initialization signal line V1 is transmitted to the first node N1, so as to reset the first node N1, which is conducive to improving the stability of the driving transistor T1 included in the pixel driving sub-circuit Q.

The second scanning signal transmitted by the second scanning signal line G2 includes a high voltage signal. The compensation transistor T3 is turned on, and the first initialization signal transmitted by the first initialization signal line V1 may be transmitted to the third node N3 through the compensation transistor T3, so as to reset the third node N3, which is conducive to improving the stability of the driving transistor T1 included in the pixel driving sub-circuit Q.

The second reset signal transmitted by the second reset signal line R2 includes a low voltage signal. The third reset transistor T8 is turned on, and the third initialization signal transmitted by the third initialization signal line V3 is transmitted to the second node N2, which is equivalent to resetting the first electrode a1 of the driving transistor T1. In this way, the initial state of the driving transistor T1 before the data writing phase t2 is fixed, which facilitates the driving transistor T1 to be in a stable state during the data writing phase t2, thereby greatly improving the hysteresis effect of the driving transistor T1.

And, the second reset signal transmitted by the second reset signal line R2 is a low voltage signal. In this case, the second reset transistor T7 is turned on, and the second initialization signal transmitted by the second initialization signal line V2 is transmitted to the fourth node N4, which is equivalent to resetting the anode of the light-emitting unit O, thereby improving the stability of the light-emitting unit O.

In the data writing phase t2, the enable signal transmitted by the enable signal line E1 is a high voltage signal. In this case, the first light-emitting control transistor T5 and the second light-emitting control transistor T6 are both in the turned-off state. The first reset signal transmitted by the first reset signal line R1 is a low voltage signal, and in this case, the first reset transistor T4 is in the turned-off state. The second reset signal transmitted by the second reset signal line R2 is a high voltage signal, and in this case, both the second reset transistor T7 and the third reset transistor T8 are in the turned-off state.

The second scanning signal transmitted by the second scanning signal line G2 includes a high voltage signal, and the compensation transistor T3 is turned on. And, the first scanning signal transmitted by the first scanning signal line G1 is a low voltage signal. In this case, the data writing transistor T2 is turned on, and the data writing signal transmitted by the data writing signal line 21 may be transmitted to the first node N1 through the data writing transistor T2, the driving transistor T1, and the compensation transistor T3 in sequence, so as to compensate the first node N1. The potential of the first node N1 gradually rises to a sum of Vdata and Vth (i.e., Vdata+Vth). Vdata is a voltage value of the data writing signal provided by the data writing signal line 21, and Vth is a threshold voltage of the driving transistor T1 in the pixel driving sub-circuit Q. In a case where the potential of the first node N1 is Vdata+Vth, the charging process is completed. Subsequently, the driving transistor T1 included in the pixel driving sub-circuit Q may maintain continuous conduction by utilizing the discharge of the storage capacitor Cst, so as to ensure that the light-emitting unit O emits light.

In the adjustment phase t3, the enable signal transmitted by the enable signal line E1 is a high voltage signal, and in this case the first light-emitting control transistor T5 and the second light-emitting control transistor T6 are both in the turned-off state. The first scanning signal transmitted by the first scanning signal line G1 is a high voltage signal, and in this case, the data writing transistor T2 is in a turned-off state. The second scanning signal provided by the second scanning signal line G2 is a low voltage signal, and in this case, the compensation transistor T3 is in the turned-off state. The first reset signal transmitted by the first reset signal line R1 is a low voltage signal, and in this case, the first reset transistor T4 is in the turned-off state.

The second reset signal transmitted by the second reset signal line R2 includes a low voltage signal. The third reset transistor T8 is turned on, and the third initialization signal transmitted by the third initialization signal line V3 is transmitted to the second node N2, which is equivalent to resetting the first electrode a1 of the driving transistor T1. In this way, the initial state of the driving transistor T1 before the data writing phase t2 is fixed, which facilitates the driving transistor T1 to be in a stable state during the data writing phase t2, thereby greatly improving the hysteresis effect of the driving transistor T1.

And, the second reset signal transmitted by the second reset signal line R2 is a low voltage signal. In this case, the second reset transistor T7 is turned on, and the second initialization signal transmitted by the second initialization signal line V2 is transmitted to the fourth node N4, which is equivalent to resetting the anode of the light-emitting unit O, thereby improving the stability of the light-emitting unit O.

In the light-emitting phase t4, the second scanning signal provided by the second scanning signal line G2 is a low voltage signal, and in this case, the compensation transistor T3 is in the turned-off state. The first reset signal transmitted by the first reset signal line R1 is a low voltage signal, and in this case, the first reset transistor T4 is in the turned-off state. The first scanning signal transmitted by the first scanning signal line G1 is a high voltage signal, and in this case, the data writing transistor T2 is in the turned-off state. The second reset signal transmitted by the second reset signal line R2 is a high voltage signal, and in this case, both the second reset transistor T7 and the third reset transistor T8 are in the turned-off state.

And, the enable signal transmitted by the enable signal line E1 is a low voltage signal, and in this case, the first light-emitting control transistor T5 and the second light-emitting control transistor T6 are both turned on. In this case, the driving transistor T1 included in the pixel driving sub-circuit Q may maintain continuous conduction by utilizing the discharge of the storage capacitor Cst. Based on this, the constant voltage power signal provided by the first power signal line VDD may flow through the first light-emitting control transistor T5, the driving transistor T1, and the second light-emitting control transistor T6 in sequence to the anode of the light-emitting unit O, and the cathode of the light-emitting unit O may be electrically connected to the second power signal line VSS, thereby driving the light-emitting unit O to emit light. The first power signal line VDD may be a high power signal line, and the second power signal line VSS may be a low power signal line.

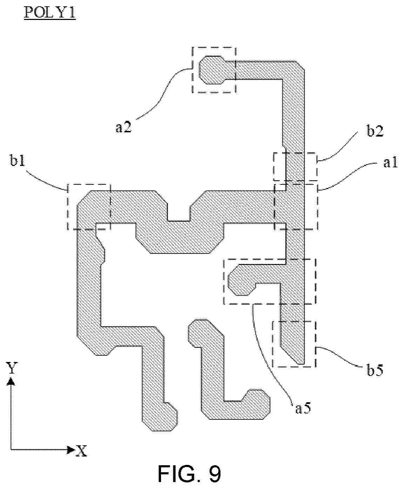

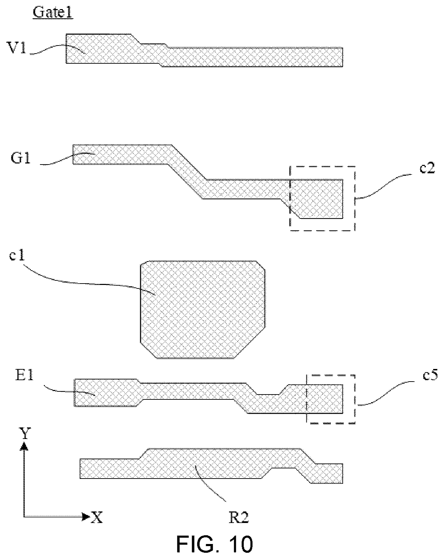

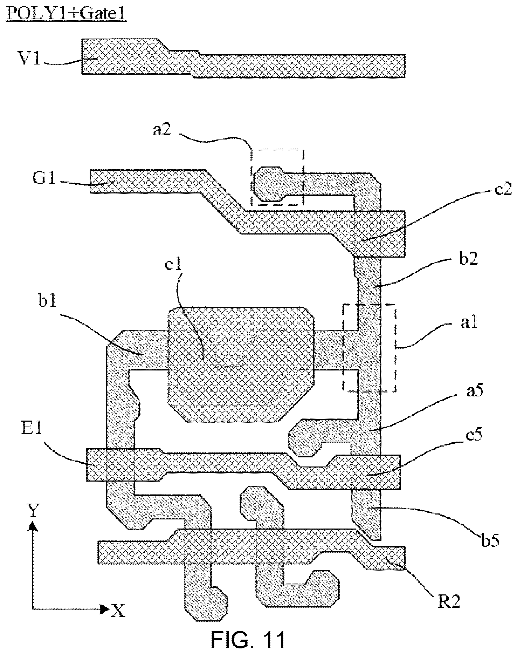

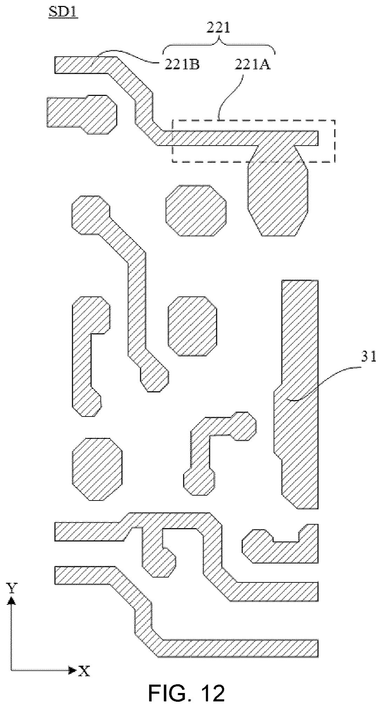

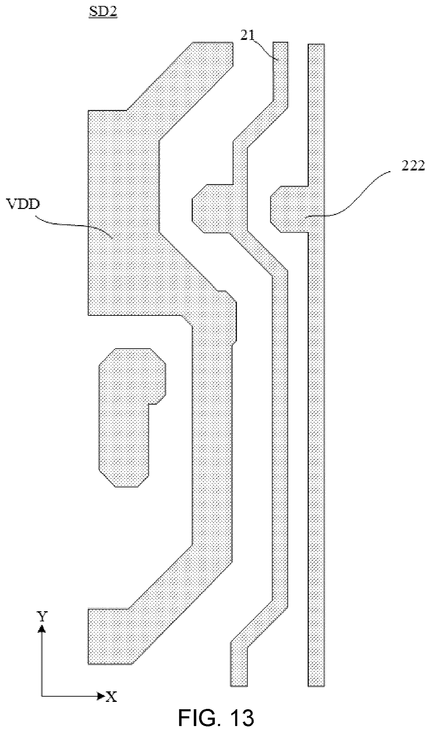

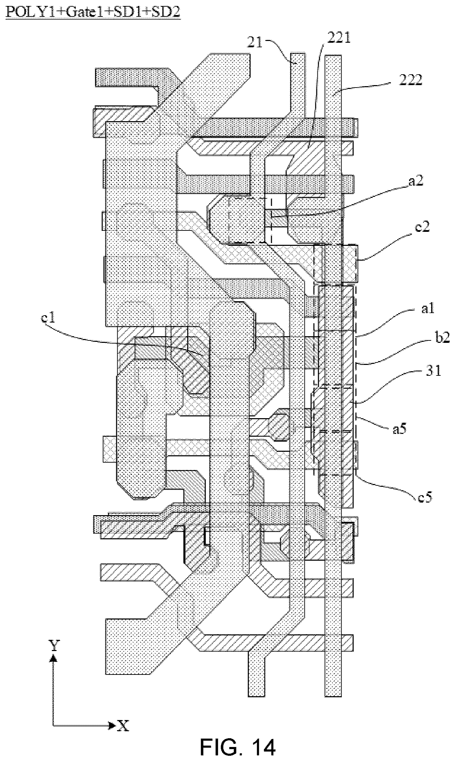

FIG. 9 is a diagram showing a film layer of the first semiconductor layer in FIG. 5; FIG. 10 is a diagram showing a film layer of the first gate metal layer in FIG. 5; FIG. 11 is a diagram showing film layers of the first semiconductor layer and the first gate metal layer in FIG. 5; FIG. 12 is a diagram showing a film layer of the first wiring metal layer in FIG. 5; FIG. 13 is a diagram showing a film layer of the second wiring metal layer in FIG. 5; and FIG. 14 is a diagram showing film layers of the first semiconductor layer, the first gate metal layer, the first wiring metal layer, and the second wiring metal layer in FIG. 5.

In some embodiments, referring to FIGS. 5 and 9 to 14, in a case where the orthogonal projection of the second lead segment 222 on the base substrate 10, the orthogonal projection of the first shielding pattern 31 on the base substrate 10, and the orthogonal projection of the first electrode a1 of the driving transistor T1 on the base substrate 10 overlap,

The second lead segment 222 and the first shielding pattern 31 may be disposed on a same side of the gate c1 of the same driving transistor T1 along the first direction X. That is, in the first direction X, the second lead segment 222 and the first shielding pattern 31 are concentrated on a side of the gate c1 of the driving transistor T1, which is equivalent to concentrating the second lead segment 222 and the first shielding pattern 31 at a position corresponding to the edge area of the pixel driving sub-circuit Q.

In this way, the second lead segment 222 and the first shielding pattern 31 may better avoid other transistors in the pixel driving sub-circuit Q, better avoid the gate c1 of the driving transistor T1 and the second electrode b1 of the driving transistor T1, and only have an overlapping area with the first electrode a1 of the driving transistor T1.

Based on this, it may be conducive to increasing a distance between the second lead segment 222 and the gate c1 of the driving transistor T1, and a distance between the second lead segment 222 and the second electrode b1 of the driving transistor T1, reducing the parasitic capacitance formed between the second lead segment 222 and the gate c1 of the driving transistor T1, and reducing the parasitic capacitance formed between the second lead segment 222 and the second electrode b1 of the driving transistor T1. In this way, the influence of the data writing signal transmitted by the second lead segment 222 to the data writing signal line 21 on the voltage at the gate c1 of the driving transistor T1 and the second electrode b1 of the driving transistor T1 may be prevented when the data writing signal jumps, thereby facilitating improving the stability of the driving transistor T1 in the pixel driving sub-circuit Q. In addition, it is further conducive to planning the layout of the first shielding pattern 31, so that the first shielding pattern 31 may block the first electrode a1 of the driving transistor T1 to a greater extent, thereby preventing the influence of the data writing signal transmitted by the second lead segment 222 to the data writing signal line 21 on the potential of the first electrode a1 of the driving transistor T1 when the data writing signal jumps, which is conducive to improving the stability of the driving transistor T1 of the pixel driving sub-circuit Q.

In summary, the relative positions of the second lead segment 222 of the data lead 22, the driving transistor T1 (e.g., the first electrode a1 of the driving transistor T1, the second electrode b1 of the driving transistor T1 and the gate c1 of the driving transistor T1) and the first shielding pattern 31 are set in such arrangement, which may conducive to reducing the parasitic capacitance formed between the second lead segment 222 of the data lead 22 and the driving transistor T1, and further conducive to preventing the second lead segment 222 of the data lead 22 from causing the potential jump of the driving transistor T1, so as to improve the stability of the driving transistor T1 and improve the brightness uniformity of the display panel 100.

In some examples, the capacitance value of the parasitic capacitance formed between the second lead segment 222 of the data lead 22 and the driving transistor T1 (e.g., the first electrode a1 of the driving transistor T1, the second electrode b1 of the driving transistor T1, and the gate c1 of the driving transistor T1) is not greater than 0.01 fF.

For example, the capacitance value of the parasitic capacitance formed between the second lead segment 222 of the data lead 22 and the first electrode a1 of the driving transistor T1 is not greater than 0.01 fF.

For example, the capacitance value of the parasitic capacitance formed between the second lead segment 222 of the data lead 22 and the second electrode b1 of the driving transistor T1 is not greater than 0.01 fF.

For example, the capacitance value of the parasitic capacitance formed between the second lead segment 222 of the data lead 22 and the gate c1 of the driving transistor T1 is not greater than 0.01 fF.

Such arrangement may make the capacitance value of the parasitic capacitance formed between the second lead segment 222 of the data lead 22 and the driving transistor T1 lower, thereby preventing the second lead segment 222 of the data lead 22 from causing the potential jump of the driving transistor T1, and further improving the stability of the driving transistor T1 and improving the brightness uniformity of the display panel 100.

The overlapping relationships between the second lead segment 222, the first shielding pattern 31 and the driving transistor T1 are introduced above with reference to the accompanying drawings. On this basis, a positional relationship between the first shielding pattern 31 and multiple transistors in the pixel driving sub-circuit Q will be introduced below with reference to relevant drawings.

In some embodiments, with reference to FIGS. 5 and 7 to 14, the pixel driving sub-circuit Q further includes a writing sub-circuit 101. The writing sub-circuit 101 is coupled to the first scanning signal line G1, the data writing signal line 21 and the second node N2. The writing sub-circuit 101 is configured to transmit a data signal received at the data writing signal line 21 to the second node under control of the first scanning signal received from the first scanning signal line G1 during a writing phase.

In some examples, the writing sub-circuit 101 includes a data writing transistor T2. A gate c2 of the data writing transistor T2 is electrically connected to the first scanning signal line G1, a first electrode a2 of the data writing transistor T2 is electrically connected to the data writing signal line 21, and a second electrode b2 of the data writing transistor T2 is electrically connected to the second node N2.

Since the first electrode a1 of the driving transistor T1 is electrically connected to the second node N2, and the second electrode b2 of the data writing transistor T2 is electrically connected to the second node N2, the second electrode b2 of the data writing transistor T2 is electrically connected to the first electrode a1 of the driving transistor T1.

Based on the connection relationship between the driving transistor T1 and the data writing transistor T2 in the above-mentioned pixel driving sub-circuit Q, the data writing transistor T2 is disposed at a side of the driving transistor T1 along the second direction Y. And, at least a portion of the first shielding pattern 31 is located between the gate c1 of the driving transistor T1 and the gate c2 of the data writing transistor T2.

It will be noted that, the data writing transistor T2 is located on a side of the driving transistor T1 along the second direction Y, which may be understood that the data writing transistor T2 is located at any position of two sides of the driving transistor T1 along the second direction Y. That is, the data writing transistor T2 may be located directly above, obliquely above, directly below, or obliquely below the driving transistor T1 along the second direction Y. FIG. 5 illustrates an example in which the data writing transistor T2 is located obliquely above the driving transistor T1.

Since the first electrode a1 of the driving transistor T1 is located between the gate c1 of the driving transistor T1 and the gate c2 of the data writing transistor T2, the first shielding pattern 31 may better shield the first electrode a1 of the driving transistor T1 by arranging the first shielding pattern 31 between the gate c1 of the driving transistor T1 and the gate c2 of the data writing transistor T2. That is, the first shielding pattern 31 may better isolate the first electrode a1 of the driving transistor T1 and the second lead segment 222 of the data lead 22, which may conducive to preventing the second lead segment 222 of the data lead 22 from causing the potential jump of the first electrode a1 of the driving transistor T1, improving the stability of the driving transistor T1, and improving the brightness uniformity of the display panel 100.

In some examples, with reference to FIGS. 5 and 7 to 14, since the second electrode b2 of the data writing transistor T2 and the first electrode a1 of the driving transistor T1 are electrically connected, and the data writing transistor T2 and the driving transistor T1 are arranged along the second direction Y, the data writing transistor T2 and the driving transistor T1 are arranged along the extending direction of the second lead segment 222. And, the second electrode b2 of the data writing transistor T2 is located on a side of the gate electrode c2 of the data writing transistor T2 proximate to the driving transistor T1. Based on this, the orthogonal projection of the second lead segment 222 on the base substrate 10 and the orthogonal projection of the second electrode b2 of the data writing transistor T2 on the base substrate 10 may have an overlapping area.

As in the above structure, at least a portion of the first shielding pattern 31 may be located between the gate c1 of the driving transistor T1 and the gate c2 of the data writing transistor T2, so that the orthogonal projection of the first shielding pattern 31 located between the gate c1 of the driving transistor T1 and the gate c2 of the data writing transistor T2 on the base substrate 10 may overlap with the orthogonal projection of the first electrode a1 of the driving transistor T1 on the base substrate 10, and the orthogonal projection of the first shielding pattern 31 located between the gate c1 of the driving transistor T1 and the gate c2 of the data writing transistor T2 on the base substrate 10 may overlap with the orthogonal projection of the second electrode b2 of the data writing transistor T2 on the base substrate 10.

Furthermore, in a case where the first shielding pattern 31 isolates the first electrode a1 of the driving transistor T1 and the second lead segment 222 of the data lead 22, the second electrode b2 of the data writing transistor T2 and the second lead segment 222 of the data lead 22 may be isolated simultaneously, so as to prevent the second lead segment 222 of the data lead 22 from causing a potential jump of the second electrode b2 of the data writing transistor T2, which may cause a potential jump of the first electrode a1 of the driving transistor T1. In this way, it is conducive to improving the stability of the driving transistor T1 and improving the brightness uniformity of the display panel 100.

"At least a portion of the first shielding pattern 31 is located between the gate c1 of the driving transistor T1 and the gate c2 of the data writing transistor T2", includes following two situations.

In a first situation, a portion of the first shielding pattern 31 is located between the gate c1 of the driving transistor T1 and the gate c2 of the data writing transistor T2. That is, the first shielding pattern 31 may be extended based on the spatial positions of each film layer of the pixel driving sub-circuit Q, so that a portion of the first shielding pattern 31 may also be provided at other positions. FIG. 5 illustrates the first situation as an example.

In a second situation, the entire first shielding pattern 31 is located between the gate c1 of the driving transistor T1 and the gate c2 of the data writing transistor T2.

In some embodiments, with reference to FIGS. 5 and 7 to 14, the pixel driving sub-circuit Q further includes a light-emitting control sub-circuit 104. The light-emitting control sub-circuit 104 is coupled to the enable signal line E1, the first power signal line VDD, the second node N2, and a fourth node N4. The light-emitting control sub-circuit 104 is configured to cooperate with the driving transistor T1 under control of the enable signal from the enable signal line E1 to transmit a driving signal to the fourth node N4. The fourth node N4 is electrically connected to the light-emitting unit O. That is, the light-emitting control sub-circuit 104 is configured to cooperate with the driving transistor T1 to transmit the driving signal to the light-emitting unit O under the control of the enable signal from the enable signal line E1.

In some examples, the light-emitting control sub-circuit 104 includes a first light-emitting control transistor T5 and a second light-emitting control transistor T6. A gate c5 of the first light-emitting control transistor T5 is electrically connected to the enable signal line E1, a first electrode a5 of the first light-emitting control transistor T5 is electrically connected to the second node N2, and a second electrode b5 of the first light-emitting control transistor T5 is electrically connected to the first power signal line VDD. A gate c6 of the second light-emitting control transistor T6 is electrically connected to the enable signal line E1, a first electrode a6 of the second light-emitting control transistor T6 is electrically connected to the third node N3, and a second electrode b6 of the second light-emitting control transistor T6 is electrically connected to the fourth node N4.

Since the first electrode a1 of the driving transistor T1 is electrically connected to the second node N2, the second electrode b2 of the data writing transistor T2 is electrically connected to the second node N2, and the first electrode a5 of the first light-emitting control transistor T5 is electrically connected to the second node N2, the first electrode a1 of the driving transistor T1, the second electrode b2 of the data writing transistor T2 and the first electrode a5 of the first light-emitting control transistor T5 are electrically connected to the same second node N2.

Based on the connection relationship of the data writing transistor T2, the first light-emitting control transistor T5 and the driving transistor T1 in the above-mentioned pixel driving sub-circuit Q, along the second direction Y, the first light-emitting control transistor T5 may be disposed at a side of the driving transistor T1 away from the data writing transistor T2, and at least a portion of the first shielding pattern 31 is located between the gate c1 of the driving transistor T1, the gate c2 of the data writing transistor T2 and the gate c5 of the first light-emitting control transistor T5.

It will be noted that, along the second direction Y, the first light-emitting control transistor T5 is located on the side of the driving transistor T1 away from the data writing transistor T2, which may be understood that the first light-emitting control transistor T5 is located at any position of the side of the driving transistor T1 away from the data writing transistor T2. That is, in a case where the data writing transistor T2 is located obliquely above the driving transistor T1, the first light-emitting control transistor T5 may be located either directly below or obliquely below the driving transistor T1 along the second direction Y. FIG. 5 illustrates an example in which the first light-emitting control transistor T5 is located obliquely above the driving transistor T1.

Since the first electrode a1 of the driving transistor T1, the second electrode b2 of the data writing transistor T2 and the first electrode a5 of the first light-emitting control transistor T5 are electrically connected to the same second node N2, the first electrode a1 of the driving transistor T1, the second electrode b2 of the data writing transistor T2 and the first electrode a5 of the first light-emitting control transistor T5 may be set to be electrically connected to the same second node N2, and located in an area surrounded by the gate c2 of the data writing transistor T2, the gate c5 of the first light-emitting control transistor T5 and the gate c1 of the driving transistor T1, so as to realize the electrical connection between the first electrode a1 of the driving transistor T1, the second electrode b2 of the data writing transistor T2 and the first electrode a5 of the first light-emitting control transistor T5.

Based on the above-mentioned relative position relationship of the data writing transistor T2, the first light-emitting control transistor T5 and the driving transistor T1, the first shielding pattern 31 may be disposed in the area surrounded by the gate c2 of the data writing transistor T2, the gate c5 of the first light-emitting control transistor T5 and the gate c1 of the driving transistor T1. Furthermore, the orthogonal projection of the first shielding pattern 31 on the base substrate 10 may overlap with the orthogonal projection of the first electrode a1 of the isolated driving transistor T1 on the base substrate 10, so that the first shielding pattern 31 may be used to better isolate the first electrode a1 of the driving transistor T1 and the second lead segment 222 of the data lead 22, which may be conducive to preventing the second lead segment 222 of the data lead 22 from causing a potential jump of the first electrode a1 of the driving transistor T1, improving the stability of the driving transistor T1, and improving the brightness uniformity of the display panel 100.

In some examples, the first electrode a1 of the driving transistor T1, the second electrode b2 of the data writing transistor T2 and the first electrode a5 of the first light-emitting control transistor T5 are electrically connected to the same second node N2, and along the second direction Y, the data writing transistor T2, the driving transistor T1 and the first light-emitting control transistor T5 are arranged in sequence, therefore, the data writing transistor T2, the driving transistor T1 and the first light-emitting control transistor T5 are arranged along the extending direction of the second lead segment 222.

Based on this, the orthogonal projection of the second lead segment 222 on the base substrate 10 may have an overlapping area with the orthogonal projection of the second electrode b2 of the data writing transistor T2 on the base substrate 10, and the orthogonal projection of the second lead segment 222 on the base substrate 10 may have an overlapping area with the orthogonal projection of the first electrode a5 of the first light-emitting control transistor T5 on the base substrate 10.

For example, the second electrode b2 of the data writing transistor T2 is located on a side of the gate c2 of the data writing transistor T2 proximate to the driving transistor T1, and the first electrode a5 of the first light-emitting control transistor T5 is located on a side of the gate c5 of the first light-emitting control transistor T5 proximate to the driving transistor T1.

Based on this, in a case where at least a portion of the first shielding pattern 31 is located between the gate c1 of the driving transistor T1, the gate c2 of the data writing transistor T2 and the gate c5 of the first light-emitting control transistor T5, and in a case where the orthogonal projection of the first shielding pattern 31 on the base substrate 10 may overlap with the orthogonal projection of the first electrode a1 of the driving transistor T1 on the base substrate 10, the orthogonal projection of the first shielding pattern 31 on the base substrate 10 may also overlap with the orthogonal projection of the second electrode b2 of the data writing transistor T2 on the base substrate 10, and the orthogonal projection of the first shielding pattern 31 on the base substrate 10 may also overlap with the orthogonal projection of the first electrode a5 of the first light-emitting control transistor T5 on the base substrate 10.

Furthermore, the first shielding pattern 31 may isolate the second electrode b2 of the data writing transistor T2 and the second lead segment 222 of the data lead 22, and isolate the first electrode a5 of the first light-emitting control transistor T5 and the second lead segment 222 of the data lead 22 in a case where the first shielding pattern 31 isolates the first electrode a1 of the driving transistor T1 and the second lead segment 222 of the data lead 22. In this way, it may prevent the second lead segment 222 of the data lead 22 from causing a potential jump of the second electrode b2 of the data writing transistor T2, which in turn causes a potential jump of the first electrode a1 of the driving transistor T1. And, it may prevent the second lead segment 222 of the data lead 22 from causing a potential jump of the first electrode a5 of the first light-emitting control transistor T5, which in turn causes a potential jump of the first electrode a1 of the driving transistor T1. This is conducive to improving the stability of the driving transistor T1 and improving the brightness uniformity of the display panel 100.

"At least a portion of the first shielding pattern 31 is located between the gate c1 of the driving transistor T1, the gate c2 of the data writing transistor T2 and the gate c5 of the first light-emitting control transistor T5" includes following two situations.

In a first situation, a portion of the first shielding pattern 31 is located between the gate c1 of the driving transistor T1, the gate c2 of the data writing transistor T2, and the gate c5 of the first light-emitting control transistor T5. That is, the first shielding pattern 31 may be extended based on a spatial position of each film layer of the pixel driving sub-circuit Q, so that a portion of the first shielding pattern 31 may also be provided at other positions. FIG. 5 illustrates the first situation as an example.

In a second situation, the entire first shielding pattern 31 is located between the gate c1 of the driving transistor T1, the gate c2 of the data writing transistor T2, and the gate c5 of the first light-emitting control transistor T5.

The positional relationships between the first shielding pattern 31 and the multiple transistors in the pixel driving sub-circuit Q are introduced above with reference to the relevant drawings. The positional relationship between the first lead segment 221 in the data lead 22 and the pixel driving sub-circuit Q will be introduced below with reference to the relevant drawings.

In some embodiments, referring to FIGS. 5 and 7 to 14, the pixel driving sub-circuit Q further includes a first reset sub-circuit 103, and the first reset sub-circuit 103 is coupled to the first reset signal line R1, the first initialization signal line V1 and the first node N1. The first reset sub-circuit 103 is configured to transmit a first initialization signal received at the first initialization signal line V1 to the first node N1 under control of a first reset signal received from the first reset signal line R1, and reset the first node N1 during an initialization phase, which is conducive to ensuring the stability of the voltage of the first node N1.

In some examples, the first reset sub-circuit 103 includes a first reset transistor T4. A gate c4 of the first reset transistor T4 is electrically connected to the first reset signal line R1, a first electrode a4 of the first reset transistor T4 is electrically connected to the first node N1, and a second electrode b4 of the first reset transistor T4 is electrically connected to the first initialization signal line V1.

Since the first electrode a4 of the first reset transistor T4 is electrically connected to the first node N1, and the gate c1 of the driving transistor T1 is electrically connected to the first node N1, the first electrode a4 of the first reset transistor T4 is electrically connected to the gate c1 of the driving transistor T1.

Based on the connection condition of the each transistor in the above-mentioned pixel driving sub-circuit Q, along the second direction Y, a first reset transistor T4 of a pixel driving sub-circuit Q in a pixel circuit unit P is located on a side of the data writing transistor T2 away from the driving transistor T1, and at least a portion of the first lead segment 221 extending through the same pixel circuit unit P is located on a side of the first reset transistor T4 away from the data writing transistor T2.

As shown in FIG. 5, at least a portion of the first lead segment 221 of the data lead 22 is located on the side of the first reset transistor T4 away from the data writing transistor T2, which is equivalent to arranging the first lead segment 221 of the data lead 22 in a top edge area or a bottom edge area of the pixel driving sub-circuit Q, so that the first lead segment 221 of the data lead 22 may better avoid the driving transistor T1 and other transistors in the pixel driving sub-circuit Q. FIG. 5 illustrates an example in which the first lead segment 221 of the data lead 22 is arranged at the top of the pixel driving sub-circuit Q.

Such arrangement may help increase a distance between the first lead segment 221 and the driving transistor T1 in the pixel driving sub-circuit Q, and may further increase distances between the first lead segment 221 and other transistors in the pixel driving sub-circuit Q. In this way, the parasitic capacitance formed between the first lead segment 221 and the driving transistor T1 in the pixel driving sub-circuit Q, and the parasitic capacitances between the first lead segment 221 and other transistors may be reduced, thereby improving the influence of the data writing signal transmitted by the first lead segment 221 of the data lead 22 on the potential of the driving transistor T1 of the pixel driving sub-circuit Q when the data writing signal jumps, which is conducive to improving the stability of the driving transistor T1 in the pixel driving sub-circuit Q. In addition, it may also be conducive to preventing the first lead segment 221 from causing the potential jumps of other transistors in the pixel driving sub-circuit Q, which is conducive to improving the brightness uniformity of the display panel 100.

In some examples, the capacitance value of the parasitic capacitance formed between the first lead segment 221 of the data lead 22 and the driving transistor T1 (the first electrode a1 of the driving transistor T1, the second electrode b1 of the driving transistor T1, and the gate c1 of the driving transistor T1) is not greater than 0.01 fF.

Such arrangement may make the capacitance value of the parasitic capacitance formed between the first lead segment 221 of the data lead 22 and the driving transistor T1 lower, which is conducive to preventing the first lead segment 221 of the data lead 22 from causing the potential jump of the driving transistor T1, thereby improving the stability of the driving transistor T1 and improving the brightness uniformity of the display panel 100.

It will be noted that "extending through" may be understood that the orthographic projection of the first lead segment 221 on the base substrate 10 has overlap with and the orthographic projection of the pixel circuit unit P on the base substrate 10.

In some embodiments, with reference to FIGS. 5 and 7 to 14, on the basis that at least a portion of the first lead segment 221 of the data lead 22 is located on a side of the first reset transistor T4 away from the data writing transistor T2, that is, the first lead segment 221 of the data lead 22 is arranged at the top or bottom of the pixel driving sub-circuit Q, the first lead segment 221 includes a main body 221Aand an avoidance portion 221B arranged in the first direction X, and the avoidance portion 221B protrudes relative to the main body 221A toward a side away from the driving transistor T1, so that the avoidance portion 221B is located on a side of the first reset transistor away from the data writing transistor T2.

It can be understood that in a case where the first lead segment 221 of the data lead 22 is arranged in the top edge area or the bottom edge area of the pixel driving sub-circuit Q, it is also necessary to set the first lead segment 221 as proximate to the inside of the pixel driving sub-circuit Q as possible, so that the first lead segment 221 and the pixel driving sub-circuit Q may be arranged in a concentrated manner, which is convenient for the layout of other adjacent pixel driving sub-circuits Q. Since the first reset transistor T4 is also located in the edge area, the orthogonal projection of the first lead segment 221 on the base substrate 10 may have an overlap with the orthogonal projection of the first reset transistor T4 on the base substrate 10.

Based on this, the first lead segment 221 may be set to include the main body 221A and the avoidance portion 221B. The avoidance portion 221B protrudes relative to the main body 221A to the side away from the driving transistor T1, and the avoidance portion 221B is used to avoid the first reset transistor T4 to increase the distance between the first lead segment 221 and the first reset transistor T4, which is also equivalent to increasing the distance between the first lead segment 221 and the driving transistor T1. Therefore, it may be conducive to preventing the first lead segment 221 of the data lead 22 from causing the potential jumps of the driving transistor T1 and the first reset transistor T4, and conducive to improving the brightness uniformity of the display panel 100.

The above text, with reference to the relevant drawings, is mainly introduced by taking an example in which one pixel driving power supply P includes one sub-pixel driving short circuit Q. The following, with reference to the relevant drawings, will be introduced by taking an example in which one pixel driving power supply P includes two sub-pixel driving short circuits Q.

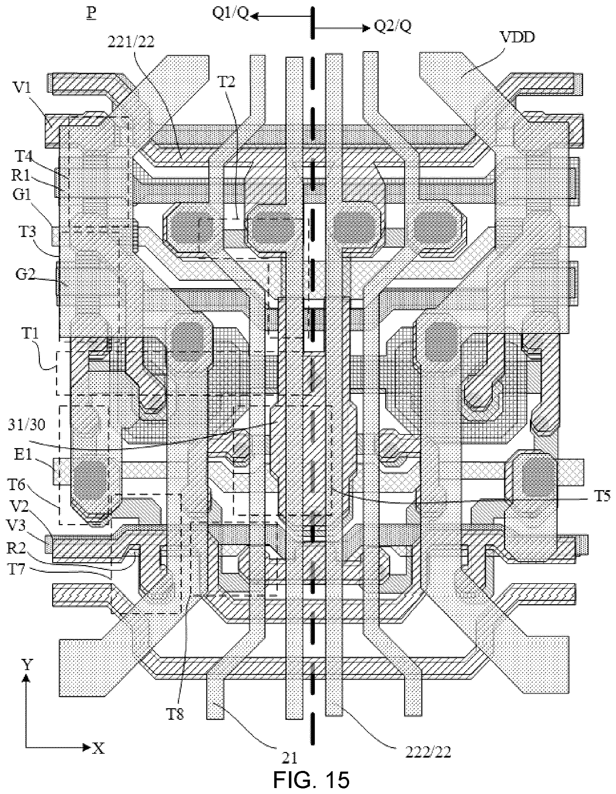

FIG. 15 is a structural diagram showing a film layer of a pixel driving unit, in accordance with some other embodiments. FIG. 15 illustrates an example in which one pixel driving unit P includes two pixel driving sub-circuits Q.

In some embodiments, referring to FIG. 15, one pixel circuit unit P includes two pixel driving sub-circuits Q arranged along the first direction X, and the two pixel driving sub-circuits Q are respectively a first pixel driving sub-circuit Q1 and a second pixel driving sub-circuit Q2. A second lead segment 222 corresponding to the first pixel driving sub-circuit Q1 is adjacent to a second lead segment 222 corresponding to the second pixel driving sub-circuit Q2.

That is, the second lead segment 222 corresponding to the first pixel driving sub-circuit Q1 is arranged at an edge area of the first pixel driving sub-circuit Q1 proximate to the second pixel driving sub-circuit Q2, and the second lead segment 222 corresponding to the second pixel driving sub-circuit Q2 is arranged at an edge area of the second pixel driving sub-circuit Q2 proximate to the first pixel driving sub-circuit Q1.

Such arrangement may help the second lead segments 222 avoid a distance between the driving transistors T1 in the pixel driving sub-circuits Q, that is, it may be conducive to increasing a distance between the second lead segment 222 and the driving transistor T1 of the pixel driving sub-circuit Q corresponding to the second lead segment 222. **In** this way, it may prevent the formation of parasitic capacitance between the second lead segment 222 and the driving transistor **T1** of the pixel driving sub-circuit Q corresponding to the second lead segment 222, which is conducive to preventing the first lead segment 221 of the data lead 22 from causing the potential jump of the driving transistor **T1,** thereby improving the stability of the driving transistor **T1** and improving the brightness uniformity of the display panel 100.

**It** can be understood that, in some other embodiments, the second lead segment 222 corresponding to the first pixel driving sub-circuit Q1 may be arranged at an edge area of the first pixel driving sub-circuit Q1 farthest from the second pixel driving sub-circuit Q2, and the second lead segment 222 corresponding to the second pixel driving sub-circuit Q2 may be arranged at an edge area of the second pixel driving sub-circuit Q2 farthest from the first pixel driving sub-circuit Q1.

Such arrangement may also help the second lead segment 222 avoid the distance between the driving transistors **T1** in the pixel driving sub-circuits Q, that is, it may be conducive to increasing the distance between the second lead segment 222 and the driving transistor **T1** in the pixel driving sub-circuit Q corresponding to the second lead segment 222. **In** this way, it may prevent the formation of parasitic capacitance between the second lead segment 222 and the driving transistor **T1** of the pixel driving sub-circuit Q corresponding to the second lead segment 222, which is conducive to preventing the first lead segment 221 of the data lead 22 from causing the potential jump of the driving transistor **T1,** thereby improving the stability of the driving transistor **T1** and improving the brightness uniformity of the display panel 100.

**It** will be noted that the second lead segment 222 corresponding to the first pixel driving sub-circuit Q1 may be a second lead segment 222 that overlaps with the first pixel driving sub-circuit Q1 in a direction perpendicular to the base substrate 10. Similarly, the second lead segment 222 corresponding to the second pixel driving sub-circuit Q2 may be a second lead segment 222 that overlaps with the second pixel driving sub-circuit Q2 in the direction perpendicular to the base substrate 10.

**In** some embodiments, referring to FIG. 15, in a case where the second lead segment 222 corresponding to the first pixel driving sub-circuit Q1 is adjacent to the second lead segment 222 corresponding to the second pixel driving sub-circuit Q2, in the same pixel circuit unit P, a first shielding pattern 31 in the first pixel driving sub-circuit Q1 is arranged adjacent to a first shielding pattern 31 in the second pixel driving sub-circuit Q2.

Such arrangement may not only use the first shielding pattern 31 to improve the voltage jump of the driving transistor T caused by the second lead segment 222, but also arrange the first shielding pattern 31 in an edge area of the pixel driving sub-circuit Q, so as to avoid each transistor in the pixel driving sub-circuit Q and increase the layout space of the first shielding pattern 31.

In some embodiments, referring to FIG. 15, in the same pixel circuit unit P, in a case where the first shielding pattern 31 in the first pixel driving sub-circuit Q1 is arranged adjacent to the first shielding pattern 31 in the second pixel driving sub-circuit Q2, the first shielding pattern 31 in the first pixel driving sub-circuit Q1 may be electrically connected to the first shielding pattern 31 in the second pixel driving sub-circuit Q2, and the first shielding pattern 31 in the first pixel driving sub-circuit Q1 and the first shielding pattern 31 in the second pixel driving sub-circuit Q2 are disposed in a same layer.

That is, the first shielding pattern 31 in the first pixel driving sub-circuit Q1 and the first shielding pattern 31 in the second pixel driving sub-circuit Q2 may be formed through a same patterning process. Thus, the manufacturing process of display panel 100 may be simplified.

In addition, since the first shielding pattern 31 needs to be configured to have the constant voltage signal, after the first shielding pattern 31 in the first pixel driving sub-circuit Q1 is electrically connected to the first shielding pattern 31 in the second pixel driving sub-circuit Q2, when the constant voltage signal is transmitted to the first shielding pattern 31 in a pixel driving sub-circuit Q of the pixel driving sub-circuit Q1 and the second pixel driving sub-circuit Q2, the first shielding pattern 31 in another pixel driving sub-circuit Q will also have the constant voltage signal, which may facilitate signal transmission.

In some embodiments, referring to FIG. 15, in the same pixel driving unit P, along the first direction X, the first pixel driving sub-circuit Q1 and the second pixel driving sub-circuit Q2 are symmetrical. Such arrangement may be conducive to improving the regularity of the display panel 100 and simplifying the difficulty of manufacturing the display panel 100.

In some examples, the first pixel driving sub-circuit Q1 and the second pixel driving sub-circuit Q2 in the same pixel driving unit P may be arranged to be mirror-symmetrical along the first direction X, which may be conducive to improving the regularity of the display panel 100 and simplifying the manufacturing difficulty of the display panel 100.

In addition, in a case where the first pixel driving sub-circuit Q1 and the second pixel driving sub-circuit Q2 are symmetrical, structures in the first pixel driving sub-circuit Q1 and the second pixel driving sub-circuit Q2 that are symmetrical and adjacent to each other may be formed through a same patterning process. Thus, the manufacturing process of display panel 100 may be simplified. For example, electrode plates of the storage capacitors Cst (as shown in FIG. 7), which need to be electrically connected to a first voltage terminal VDD, may be formed through a same patterning process, which is conducive to simplifying the manufacturing difficulty of the display panel 100.

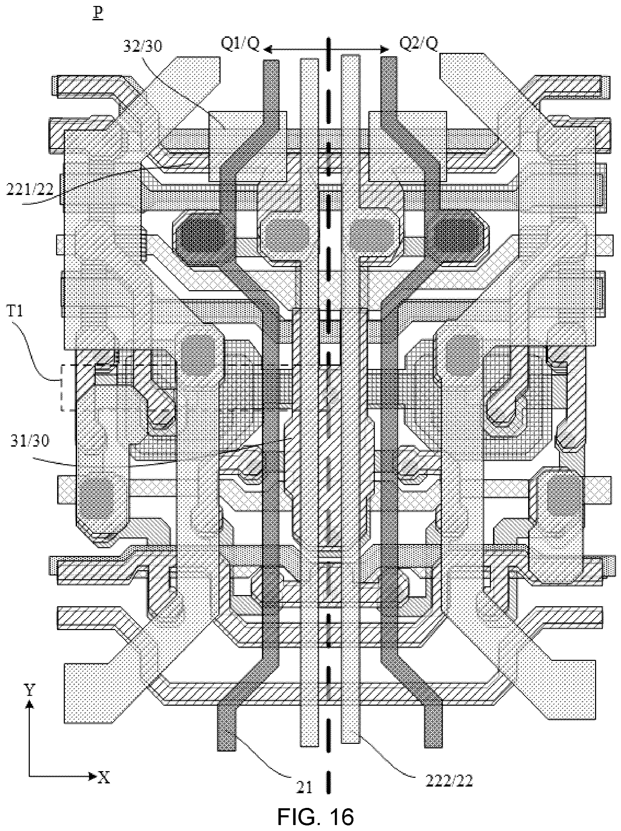

FIG. 16 is a structural diagram showing a film layer of a pixel driving unit, in accordance with yet some other embodiments.

In some embodiments, referring to FIG. 16, since the first lead segment 221 extends along the first direction X and the data writing signal line 21 extends along the second direction, there may be a situation where the orthogonal projection of the first lead segment 221 on the base substrate 10 partially overlaps with the orthogonal projection of the data writing signal line 21 on the base substrate 10. Since the first lead segment 221 may not be a portion of a data lead 22 electrically connected to the data writing signal line 21, a data writing signal transmitted by the first lead segment 221 may be different from a data writing signal transmitted by the data writing signal line 21, and thus the parasitic capacitance formed between the first lead segment 221 and the data writing signal line 21 will affect the data writing signal transmitted by the first lead segment 221 and the data writing signal transmitted by the data writing signal line 21, thereby affecting the brightness uniformity of the display panel 100.

Based on this, the shielding layer 30 in the display panel 100 may further include at least one second shielding pattern 32, and the second shielding pattern 32 is configured to have a constant voltage signal. The second shielding pattern 32 is disposed between the first lead segment 221 and the data writing signal line 21, and the orthogonal projection of the second shielding pattern 32 on the base substrate 10, the orthogonal projection of the first lead segment 221 on the base substrate 10, and the orthogonal projection of the data writing signal line 21 on the base substrate 10 overlap.

In the above structure, the second shielding pattern 32 may be used to isolate the first lead segment 221 and the data writing signal line 21, and the second shielding pattern 32 may be used to reduce the influence between the first lead segment 221 and the data writing signal line 21, which is conducive to improving the brightness uniformity of the display panel 100.

It will be noted that the data writing signal line 21 may be disposed in the third metal wiring layer, and the second shielding pattern 32 may be disposed in the second metal wiring layer, so that the second shielding pattern 32 is disposed between the first lead segment 221 and the data writing signal line 21. However, the embodiments of the present disclosure are not limited thereto.

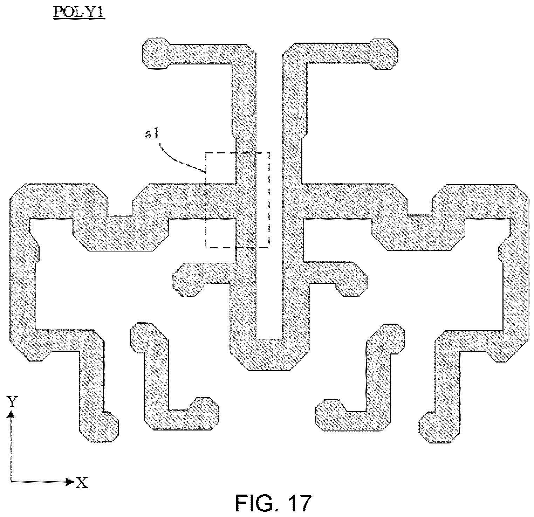

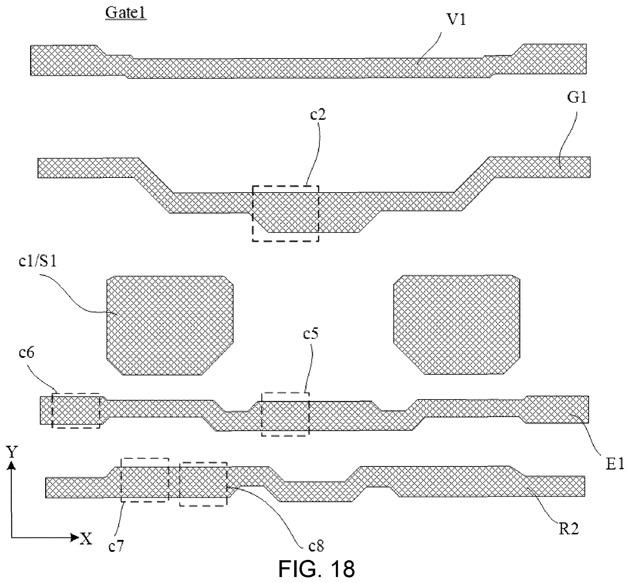

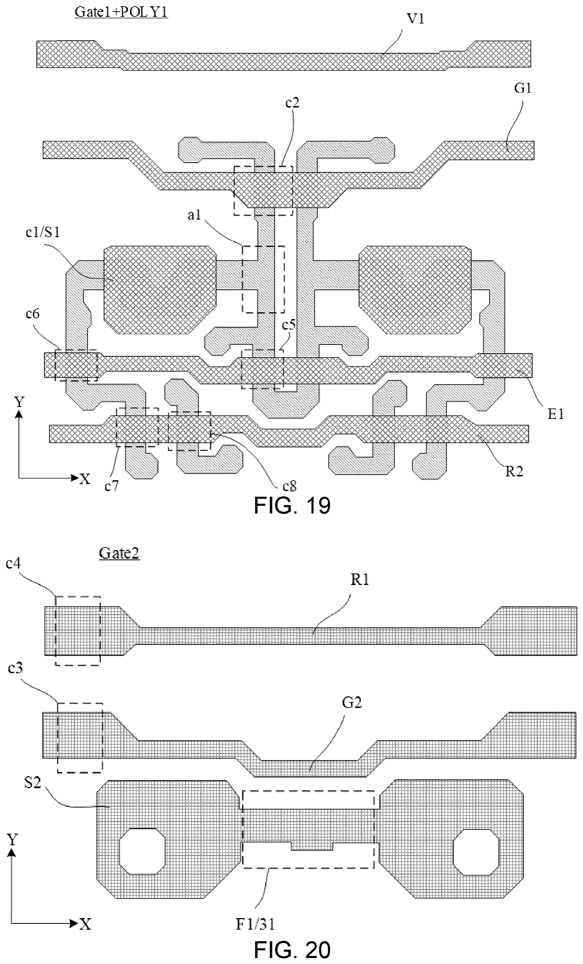

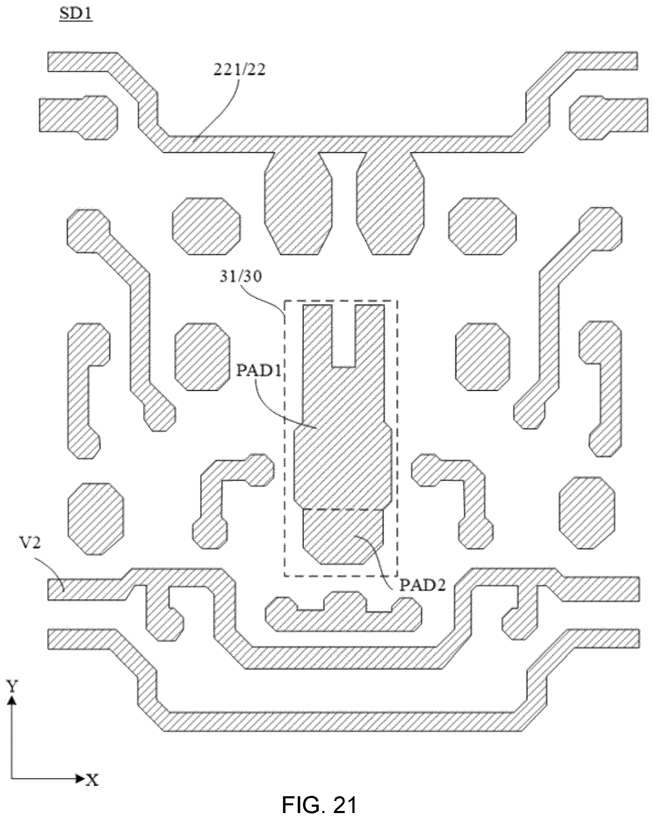

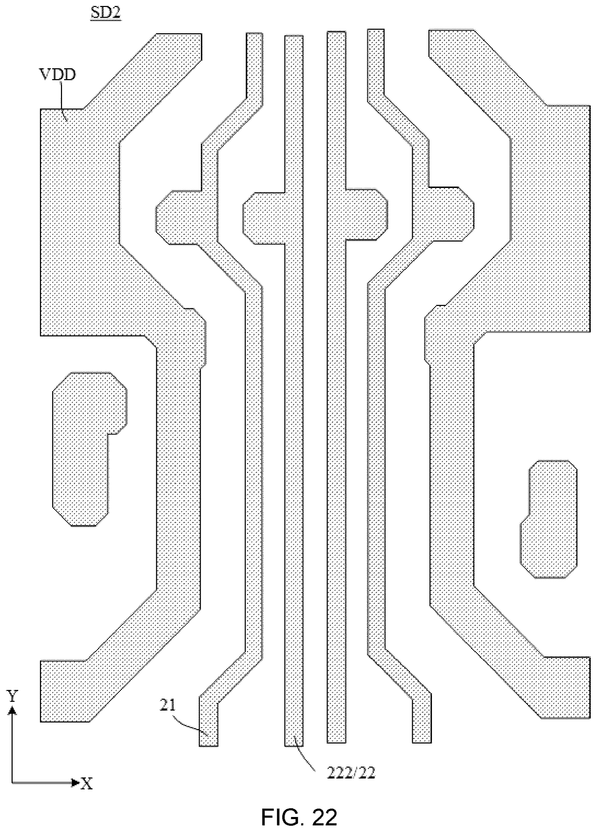

FIG. 17 is a diagram showing a film layer of the first semiconductor layer in FIG. 15; FIG. 18 is a diagram showing a film layer of the first gate metal layer in FIG. 15; FIG. 19 is a diagram showing film layers of the first semiconductor layer and the first gate metal layer in FIG. 15; FIG. 20 is a diagram showing a film layer of the second gate metal layer in FIG. 15; FIG. 21 is a diagram showing a film layer of the first wiring metal layer in FIG. 15; and FIG. 22 is a diagram showing a film layer of the second wiring metal layer in FIG. 15.

In some embodiments, referring to FIGS. 7, 15, and 17 to 22, the driving circuit layer 20 in the display panel 100 includes a plurality of metal layers. The plurality of metal layers are provided with pixel driving sub-circuits Q and multiple signal lines. The structure of the pixel driving sub-circuit Q may refer to FIG. 7. The plurality of metal layers include a first semiconductor layer POLY1, a first gate metal layer Gate1, a second gate metal layer Gate2, a first wiring metal layer SD1, and a second wiring metal layer SD2, that are stacked on the base substrate 10.

The first semiconductor layer POLY1 is located on the base substrate 10, and the first semiconductor layer POLY1 includes the first electrode a1 of the driving transistor T1 and the second electrode b1 of the driving transistor T1.

In some examples, a material of the first semiconductor layer POLY1 may include an amorphous silicon semiconductor material, a monocrystalline silicon semiconductor material, or a polycrystalline silicon semiconductor material.

The first gate metal layer Gate1 is located on a side of the first semiconductor layer POLY1 away from the base substrate 10. The first gate metal layer Gate1 includes the gate c1 of the driving transistor T1.

For example, a material of the first gate metal layer Gate1 includes conductive metal. The conductive metal includes at least one of aluminum, copper, or molybdenum, and the present disclosure is not limited thereto.

For example, the first semiconductor layer POLY1 and the first gate metal layer Gate1 are provided with a first gate insulating layer therebetween, and the first gate insulating layer may electrically insulate the first semiconductor layer POLY1 from the first gate metal layer Gate1.

For example, a material of the first insulating layer includes any of inorganic insulating materials of silicon nitride, silicon oxynitride and silicon oxide. The material of the first insulating layer includes silicon dioxide, and the present disclosure is not limited thereto.

The above is introduced by taking an example in which the first semiconductor layer POLY1 and the first gate metal layer Gate1 form the driving transistor T1 in the pixel driving sub-circuit Q. However, the first semiconductor layer POLY1 and the first gate metal layer Gate1 are further used to form a part of transistors in the pixel driving sub-circuit Q. The part of transistors may include the data writing transistor T2, the first light-emitting control transistor T5, the second light-emitting control transistor T6, and the second reset transistor T7. In a case where of the pixel driving sub-circuit Q is a pixel driving sub-circuit of "8T1C", the part of transistors further include the third reset transistor T8.

In addition, the first semiconductor layer POLY1 and the first gate metal layer Gate1 may further be used to form a part of signal lines. The part of the signal lines include the first initialization signal line V1, the enable signal line E1, the first scanning signal line G1, and the second reset signal line R2.

In some examples, the first scanning signal line G1 located in the first gate metal layer Gate1 may include a first portion, and the first portion of the first scanning signal line G1 may be further used as the gate c2 of the data writing transistor T2.

In some examples, the second reset signal line R2 located in the first gate metal layer Gate1 may include a first portion, and the first portion of the second reset signal line R2 may be further used as the gate c7 of the second reset transistor T7.

In some examples, the enable signal line E1 located in the first gate metal layer Gate1 may include a first portion and a second portion. The first portion of the enable signal line E1 may be further used as the gate of the first light-emitting control transistor T5, and the second portion of the enable signal line E1 may be further used as the gate of the second light-emitting control transistor T6.

It will be noted that an orthogonal projection of the first semiconductor layer POLY1 on the base substrate 10 overlaps with an orthogonal projection of the first gate metal layer Gate1 on the base substrate 10. A portion of the first semiconductor layer POLY1 covered by the first gate metal layer Gate1 constitute a channel portion of each transistor, and a portion of the first semiconductor layer POLY1 that is not covered by the first gate metal layer G1 is a conductive portion. The conductive portion constitutes a portion of the first electrode or the second electrode of each transistor.

The second gate metal layer Gate2 is located on a side of the first gate metal layer Gate1 away from the first semiconductor POLY1.

For example, a material of the second gate metal layer Gate2 may be the same as that of the first gate metal layer Gate1. It can be understood that, in some other examples, the second gate metal layer Gate2 may be made of a different material from the first gate metal layer Gate1. The embodiments of the present disclosure do not limit this.

For example, the second gate metal layer Gate2 and the first gate metal layer Gate1 are provided with a second gate insulating layer therebetween. The second gate insulating layer may electrically isolate the second gate metal layer Gate2 from the first gate metal layer Gate1.

For example, a material of the second insulating layer includes any of inorganic insulating materials of silicon nitride, silicon oxynitride and silicon oxide. The material of the second insulating layer may include silicon dioxide, and the present disclosure is not limited thereto.

In some embodiments, the pixel driving sub-circuit Q further includes the storage capacitor Cst. A first electrode plate S1 of the storage capacitor Cst is electrically connected to the gate c1 of the driving transistor T1, and a second electrode plate S2 of the storage capacitor Cst is electrically connected to the first power signal line VDD.

The first electrode plate S1 of the storage capacitor Cst may be located in the first gate metal layer Gate1, and the second electrode plate S2 of the storage capacitor Cst may be located in the second gate metal layer Gate2. An orthogonal projection of the first electrode S1 of the storage capacitor Cst on the base substrate 10 at least partially overlaps with an orthogonal projection of the second electrode S2 of the storage capacitor Cst on the base substrate 10, so as to form the storage capacitor Cst.

The first electrode S1 of the storage capacitor Cst located in the first gate metal layer Gate1 may be further used as the gate c1 of the driving transistor T1. Based on this, there is no need to separately provide the gate c1 of the driving transistor T1, which may conducive to simplifying the manufacturing process of the pixel driving sub-circuit Q. In addition, since the first electrode plate S1 of the storage capacitor Cst may be further used as the gate c1 of the driving transistor T1, it may further implement that the first electrode plate S1 of the storage capacitor Cst is electrically connected to the gate c1 of the driving transistor T1 directly without setting up a separate connecting portion, which may further be beneficial for the layout of the pixel driving sub-circuit Q.

In addition, the second gate metal layer Gate2 may further be used to form a part of signal lines. The part of signal lines include the first reset signal line R1 and the second scanning signal line G2.

In some examples, the first reset signal line R1 located in the second gate metal layer Gate2 may include a first portion. The first portion of the first reset signal line R1 may be further used as the gate c4 of the first reset transistor T4.

In some examples, the second scanning signal line G2 located in the second gate metal layer Gate2 may include a first portion. The first portion of the second scanning signal line G2 may be further used as the gate c3 of the compensation transistor T3.

The first wiring metal layer SD1 is located on a side of the second gate metal layer Gate2 away from the first gate metal layer Gate1.

For example, a material of the first wiring metal layer SD1 may be a titanium (Ti)-aluminum (Al)-titanium (Ti) multi-layer composite material. Based on this, a square resistance of the first wiring metal layer SD1 is about 0.05 mΩ/□.

For example, the first wiring metal layer SD1 and the second gate metal layer Gate2 are provided with a first planarization layer (PLN) therebetween. The first planarization layer may electrically insulate the first wiring metal layer SD1 and the second gate metal layer Gate2.

For example, a material of the first planarization layer is an organic material in general. For example, a material of the first planarization layer may include at least one of polyimide (PI), an acrylic-based polymer, or a silicon-based polymer.

In addition, the first wiring metal layer SD1 may further be used to form a part of signal lines. The part of signal lines include the second initialization signal line V2.

The second wiring metal layer SD2 is located on a side of the first wiring metal layer SD1 away from the first gate metal layer Gate1.

In some examples, a material of the second wiring metal layer SD2 may be the same as that of the first wiring metal layer SD1. It can be understood that the material of the second wiring metal layer SD2 may be different from that of the first wiring metal layer SD1. The embodiments of the present disclosure do not limit this.

For example, the second wiring metal layer SD2 and the first wiring metal layer SD1 are provided with a second planarization layer therebetween. The second planarization layer may electrically isolate the second wiring metal layer SD2 from the first wiring metal layer SD1.

For example, a material of the second planarization layer is an organic material in general. For example, the material of the second planarization layer may include at least one of polyimide (PI), an acrylic-based polymer, or a silicon-based polymer.

Based on the structure of the driving circuit layer 20 in the display panel 100, it can be known that the driving transistor T1 is mainly formed in the first semiconductor layer POLY1 and the first gate metal layer Gate1. In addition, a distance between the first metal wiring layer SD1 and the driving transistor T1 and a distance between the second wiring metal layer SD2 and the driving transistor T1 are greater than a distance between the second gate metal layer Gate2 and the driving transistor T1. Furthermore, by arranging the data lead 22 in the first metal wiring layer SD1 and the second wiring metal layer SD2, a distance between the data lead 22 and the driving transistor T1 may be large, which is conducive to reducing the parasitic capacitance formed between the data lead 22 and the driving transistor T1, and preventing the data lead 22 from causing the potential jump of the driving transistor T1, thereby improving the stability of the driving transistor T1 in the pixel driving sub-circuit Q and improving the brightness uniformity of the display panel 100.

For example, the first wiring metal layer SD1 may include the first lead segment 221 of the data lead 22 extending along the first direction X. The second wiring metal layer SD2 includes the second lead segment 222 of the data lead 22 extending along the second direction Y.

Compared to arranging the second lead segment 222 in the first wiring metal layer SD1, it may increase the distance between the second lead segment 222 and the driving transistor T1 by arranging the second lead segment 222 in the second wiring metal layer SD2. That is, it may increase the distance between the second lead segment 222 and the first electrode a1 of the driving transistor T1, so that the influence of the data writing signal transmitted by the second lead segment 222 to the data writing signal line 21 on the potential of the first electrode a1 of the driving transistor T1 when the data writing signal jumps may be reduced, thereby facilitating improving the stability of the driving transistor T1 in the pixel driving sub-circuit Q and improving the brightness uniformity of the display panel 100.

For example, with the above arrangement, a minimum distance between the second lead segment 222 and the gate c1 of the driving transistor T1 may be greater than or equal to 6 µm, and a minimum distance between the second lead segment 222 and the first electrode a1 of the driving transistor T1 may be greater than or equal to 18 µm.

In a case where the minimum distance between the second lead segment 222 and the gate c1 of the driving transistor T1 is equal to or close to 6 µm, and the minimum distance between the second lead segment 222 and the first electrode a1 of the driving transistor T1 is equal to or close to 18 µm, the distance between the second lead segment 222 and the gate c1 of the driving transistor T1 may be large, and the distance between the second lead segment 222 and the first electrode a1 of the driving transistor T1 may be large. Therefore, the distance between the second lead segment 222 and the first electrode a1 of the driving transistor T1 may be increased, and the influence of the data writing signal transmitted by the second lead segment 222 to the data writing signal line 21 on the potential of the first electrode a1 of the driving transistor T1 when the data writing signal jumps may be reduced, which is conducive to improving the stability of the driving transistor T1 in the pixel driving sub-circuit Q and improving the brightness uniformity of the display panel 100.

The greater the distance between the second lead segment 222 and the driving transistor T1, the better. However, due to space requirements such as the lightness and thinness of the display panel 100, the distance between the second lead segment 222 and the driving transistor T1 may be adjusted to be maximized within an appropriate degree, so as to better reduce the influence of the second lead segment 222 on the driving transistor T1, which is conducive to improving the stability of the driving transistor T1 in the pixel driving sub-circuit Q and improving the brightness uniformity of the display panel 100.

In addition, due to a difference between the material of the first metal wiring layer SD1 and the second wiring metal layer SD2 and the material of the second gate metal layer Gate2, the square resistances of the first metal wiring layer SD1 and the second wiring metal layer SD2 may be not greater than the square resistance of the second gate metal layer Gate2. In this way, the data lead 22 is disposed in the first metal wiring layer SD1 and the second wiring metal layer SD2 with a small square resistance, which is further conducive to reducing an Resistor-Capacitance (RC) impedance on the data lead 22, and reducing the transmission loss of the voltage of the data writing signal transmitted by the data lead 22, so as to prevent the voltage of the data writing signal received by the data writing signal line 21 from being reduced when the data writing signal is transmitted to the data writing signal line 21 by the data lead 22. Therefore, the data writing signals received by each pixel driving sub-circuit Q from the data writing signal line 21 are substantially equal, which is conducive to improving the brightness uniformity of the display panel 100.

The above is introduced by taking an example in which the data lead 22 is disposed in the first metal wiring layer SD1 and the second wiring metal layer SD2 as an example. However, the first metal wiring layer SD1 and the second metal wiring layer SD2 may further be used to form remaining signal lines. The remaining signal lines include the first power signal line VDD and the data writing signal line 21 and the like.

For example, the pixel circuit unit P further includes the first power signal line VDD. The first power signal line VDD is located in the second wiring metal layer SD2. The first power signal line VDD is configured to provide a constant voltage power signal to the pixel driving circuit Q.

Based on the structure of the driving circuit layer 20 in the display panel 100, it can be known that the driving transistor T1 is mainly formed in the first semiconductor layer POLY1 and the first gate metal layer Gate1, and the second lead segment 222 of the data lead 22 is formed in the second metal wiring layer SD2. It can be seen that the second lead segment 222 and the driving transistor T1 are provided with at least the second gate metal layer Gate2 and the first wiring metal layer SD1.

Furthermore, the first shielding pattern 31 may be disposed in the second gate metal layer Gate2 and/or the first wiring metal layer SD1. The film layer position of the first shielding pattern 31 may include following situations.

In a first situation, the first shielding pattern 31 is disposed in the second gate metal layer Gate2.

In a second situation, the first shielding pattern 31 is disposed in the first wiring metal layer SD1.

In a third situation, the first shielding pattern 31 is disposed in the second gate metal layer Gate2 and the first wiring metal layer SD1. That is, a portion of the first shielding pattern 31 is disposed in the second gate metal layer Gate2, and another portion of the first shielding pattern 31 is disposed in the first wiring metal layer SD2. In this case, the first shielding pattern 31 located in the second gate metal layer Gate2 needs to be electrically connected to the first shielding pattern 31 located in the first wiring metal layer SD1.

Based on this, the first shielding pattern 31 may be disposed in the metal layers (the second gate metal layer Gate2 and the first wiring metal layer SD1) sandwiched between the second lead segment 222 and the driving transistor T1 according to the layout space situation of the metal layers. The first shielding pattern 31 may be used to isolate the second lead segment 222 and the driving transistor T1, so as to ameliorate the problem of the potential jump of the driving transistor T1 caused by the second lead segment 222, thereby improving the brightness uniformity of the display panel 100. Furthermore, the space of the metal layers sandwiched between the second lead segment 222 and the driving transistor T1 may be fully utilized without separately providing a metal film layer to form the first shielding pattern 31, which is further beneficial to the lightness and thinness of the display panel 100.

In some embodiments, the shielding layer 30 may be electrically connected to the first power signal line VDD, so that the shielding layer 30 has a constant voltage signal. Based on this, there is no need to separately provide a constant voltage signal line to provide a constant voltage signal for the shielding layer 30, which may be conducive to simplifying the internal structure of the display panel 100.

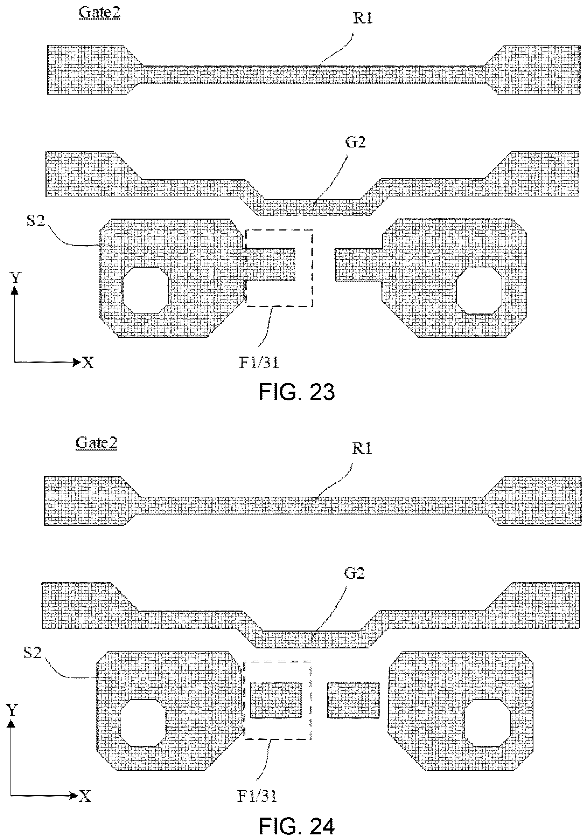

FIG. 23 is a diagram showing of a second gate metal layer of a pixel driving sub-circuit, in accordance with some embodiments.

In some embodiments, as shown in FIGS. 15, 17 to 19, and 21 to 23, the second electrode plate S2 of the storage capacitor Cst includes a first sub-portion F1. Along the direction perpendicular to the base substrate 10, the first sub-portion F1, the first electrode a1 of the driving transistor T1, and the second lead segment 222 overlap, and the first sub-portion F1 is further used as the first shielding pattern 31.

Since the second electrode S2 of the storage capacitor Cst is located in the second gate metal layer Gate2 and the second gate metal layer Gate2 is located between the first gate metal layer Gate1 and the second wiring metal layer SD2, the first shielding pattern 31 may be formed when forming the second gate metal layer Gate2.

Based on this, when the second electrode plate S2 of the storage capacitor Cst is formed in the second gate metal layer Gate2, the second electrode plate S2 of the storage capacitor Cst may be expanded to form the first sub-portion F1 of the second electrode plate S2 of the storage capacitor Cst. Along the direction perpendicular to the base substrate 10, the first sub-portion F1, the first electrode a1 of the driving transistor T1 and the second lead segment 222 overlap, that is, the second electrode S2 of the storage capacitor Cst is expanded to a position between the first electrode a1 of the driving transistor T1 and the second lead segment 222.

Furthermore, the first sub-portion F1 of the second electrode plate S2 of the storage capacitor Cst may be used to isolate the first electrode a1 of the driving transistor T1 and the second lead segment 222, so as to ameliorate the problem of the potential jump of the driving transistor T1 caused by the second lead segment 222, which is conducive to improving the stability of the driving transistor T1 and improving the uniformity of the display panel 100.

In addition, since the second electrode plate S2 of the storage capacitor Cst needs to be electrically connected to the first power signal line VDD, there is no need to separately provide the first shielding pattern (the first sub-portion F1 of the second electrode plate S2 of the storage capacitor Cst) to be electrically connected to the first power signal line VDD, which is conducive to simplifying the layout.

In some embodiments, as shown in FIGS. 15 and 17 to 22, in a case where one pixel driving unit P includes two pixel driving sub-circuits Q, the second electrode plates S2 of the storage capacitors Cst in the two pixel driving sub-circuits Q both need to be electrically connected to the first power signal lines VDD. That is, the second electrode plates S2 of the storage capacitors Cst in the two pixel driving sub-circuits Q obtain the same signals.

Based on this, the second electrode plates S2 of the storage capacitors Cst in the two pixel driving sub-circuits Q may be electrically connected, that is, the first sub-portion F1 of the second electrode plates S2 of the storage capacitors Cst in the two pixel driving sub-circuits Q may be electrically connected.

In this case, it is further conducive to increasing the size of the first sub-portion F1, that is, increasing the size of the first shielding pattern 31, which may be beneficial to causing the first shielding pattern 31 to better isolate the first electrode a1 and the second lead segment 222 of the driving transistor T1, and beneficial to improving the stability of the driving transistor T1.

In addition, in some other embodiments, as shown in FIG. 24, FIG. 24 is a diagram showing of a second gate metal layer of a pixel driving sub-circuit, in accordance with some other embodiments, and in combination with FIGS. 15, 17 to 19, 21 and 22, a first shielding pattern 31 independent of the storage capacitor Cst may further be provided in the second gate metal layer Gate2. The first shielding pattern 31 is located on a side of the second electrode plate S2 of the storage capacitor Cst proximate to the first electrode a1 of the driving transistor T1, so that an orthogonal projection of the first shielding pattern 31 on the base substrate 10 overlaps with the orthogonal projection of the first electrode a1 of the driving transistor T1 on the base substrate 10.

Based on this, the space on the second gate metal layer Gate2 may be fully utilized. By providing the first shielding pattern 31 at a position corresponding to the first electrode a1 of the driving transistor T1, the first shielding pattern 31 may be used to isolate the first electrode a1 of the driving transistor T1 from the second lead segment 222, so as to ameliorate the problem of the potential jump of the driving transistor T1 caused by the second lead segment 222, which is conducive to improving the brightness uniformity of the display panel 100.

In addition, the first shielding pattern 31 located in the second gate metal layer Gate2 may be connected to the first power signal line VDD located in the second wiring metal layer SD2 by using a conductive block in the first wiring metal layer SD1, so that the first shielding pattern 31 has a constant voltage potential.

It can be understood that the first shielding pattern 31 located in the second gate metal layer Gate2 may further be directly connected to the first power signal line VDD located in the second wiring metal layer SD2 through the via hole, so that the first shielding pattern 31 has a constant voltage potential. The embodiments of the present disclosure are not limited thereto.

In some embodiments, as shown in FIG. 15 and FIG. 17 to FIG. 22, the second electrode plate S2 of the storage capacitor Cst located in the second gate metal layer Gate2 needs to be electrically connected to the first power signal line VDD located in the second wiring metal layer SD2.

The second gate metal layer Gate2 and the first power signal line VDD are at least provided with the second gate insulating layer, the first wiring metal layer SD1 and the first planarization layer therebetween. Therefore, there are many film layers between the second gate metal layer Gate2 and the first power signal line VDD. In this case, if the film layers between the second gate metal layer Gate2 and the first power signal line VDD are directly etched to form a connecting hole through which the second electrode S2 of the storage capacitor Cst is electrically connect to the first power signal line VDD, a depth of the connecting hole will be too deep, and the manufacturing process will be difficult, which may easily lead to the problem of blind hole.

Based on this, a first connecting portion PAD1 may be formed in the first wiring metal layer SD1 between the second gate metal layer Gate2 and the first power signal line VDD. An orthogonal projection of the first connecting portion PAD1 on the base substrate 10 overlaps with an orthogonal projection of the second electrode plate S2 of the storage capacitor Cst on the base substrate 10, and the orthogonal projection of the first connecting portion PAD1 on the base substrate 10 overlaps with an orthogonal projection of the first power signal line VDD on the base substrate 10.

Furthermore, a segmented punching process may be used to form via holes in the second gate insulating layer and the first planarization layer, respectively, so that an end of the first connecting portion PAD1 may be electrically connected to the second electrode S2 of the storage capacitor Cst through the via hole in the second gate insulating layer, and another end of the first connecting portion PAD1 may be electrically connected to the first power signal line VDD through the via hole in the first planarization layer, so as to implement the electrical connection between the second electrode S2 of the storage capacitor Cst and the first power signal line VDD. The depth of the via hole may be reduced by utilizing the segmented punching process, which is conducive to reducing the difficulty of the punching process and improving the yield rate of the display panel 100.

In addition, the first connecting portion PAD1 is electrically connected to the first power signal line VDD, so that the first connecting portion PAD1 may have a constant voltage signal.

Based on this, the first connecting portion PAD1 may be arranged between the second lead segment 222 and the driving transistor T1, so that the first connecting portion PAD1 may further be used as the first shielding pattern 31. Furthermore, the first connecting portion PAD1 may be used to isolate the first electrode a1 of the driving transistor T1 and the second lead segment 222, so as to ameliorate the problem of the potential jump of the driving transistor T1 caused by the second lead segment 222, which is conducive to improving the stability of the driving transistor T1 and improving the uniformity of the display panel 100.

In addition, since the first connecting portion PAD1 may further be directly used as the first shielding pattern 31, there is no need to manufacture the first shielding pattern 31 separately in the display panel 100, which is conducive to simplifying the manufacturing process of the display panel 100.

In some embodiments, as shown in FIGS. 15 and 17 to 22, in a case where the second electrode plate S2 of the storage capacitor Cst in the second gate metal layer Gate2 includes the first sub-portion F1 and the first wiring metal layer SD1 is provided with the first connecting portion PAD1, the first connecting portion PAD1 may be used to electrically connect the first sub-portion F1 of the second electrode plate S2 of the storage capacitor Cst, so that the second electrode plate S2 of the storage capacitor Cst receives the constant voltage power signal from the first power signal line VDD by using the first connecting portion PAD1.

In this case, the first sub-portion F1 of the second electrode plate S2 of the storage capacitor Cst and the first connecting portion PAD1 are further used as the first shielding pattern 31. The first sub-portion F1 of the second electrode plate S2 of the storage capacitor Cst and the first connecting portion PAD1 may be used to isolate the first electrode a1 and the second lead segment 222 of the driving transistor T1, so as to ameliorate the problem of the potential jump of the driving transistor T1 caused by the second lead segment 222, which is conducive to improving the stability of the driving transistor T1 and improving the uniformity of the display panel 100.

In some embodiments, as shown in FIGS. 15 and 17 to 22, one pixel driving sub-circuit Q further includes the first light-emitting control transistor T5, and the second electrode b5 of the first light-emitting control transistor T5 is electrically connected to the first power signal line VDD.

Since the second electrode b5 of the first light-emitting control transistor T5 is located in the first semiconductor layer POLY1, and the first power signal line VDD is located in the second metal wiring layer SD2, there are more film layers between the second electrode b5 of the first light-emitting control transistor T5 and the first power signal line VDD. If the film layers between the first semiconductor layer POLY1 and the second metal wiring layer SD2 are etched to form a connecting hole through which the second electrode b5 of the first light-emitting control transistor T5 is electrically connected to the first power signal line VDD, the depth of the connecting hole will be too deep, and the manufacturing process will be difficult, which may easily lead to the problem of blind hole.

Based on this, a first transfer portion PAD2 may be formed in the first wiring metal layer SD1 between the first semiconductor layer POLY1 and the second metal wiring layer SD2. The segmented punching process may be used to electrically connect the first transfer portion PAD2 to the second electrode b5 of the first light-emitting control transistor T5 and the first power signal line VDD. The depth of the via hole may be reduced by utilizing the segmented punching process, which is conducive to reducing the difficulty of the punching process and improving the yield rate of the display panel 100.

In addition, the first transfer portion PAD2 is electrically connected to the first power signal line VDD, so that the first transfer portion PAD2 may have a constant voltage signal.

Based on this, the first transfer portion PAD2 may be arranged between the second lead segment 222 and the driving transistor T1, and the first transfer portion PAD2 may further be used as the first shielding pattern 31. Furthermore, the first adapter PAD2 may be used to isolate the first electrode a1 of the driving transistor T1 and the second lead segment 222, so as to ameliorate the problem of the potential jump of the driving transistor T1 caused by the second lead segment 222, which is conducive to improving the stability of the driving transistor T1 and improving the uniformity of the display panel 100.

In some embodiments, the first transfer portion PAD2 may be electrically connected to the first connecting portion PAD1 of the first wiring metal layer SD1, so as to form the first shielding pattern 31. In addition, the first transfer portion PAD2 and the first connecting portion PAD1 may be formed through a same patterning process, which is conducive to simplifying the manufacturing process of the display panel 100.

In addition, the first shielding pattern 31 is formed by the first transfer portion PAD2 and the first connecting portion PAD1, which is conducive to increasing the size of the first shielding pattern 31, so that the first shielding pattern 31 may better isolate the driving transistor T1 and the second lead segment 222, so as to improve the stability of the driving transistor T1.

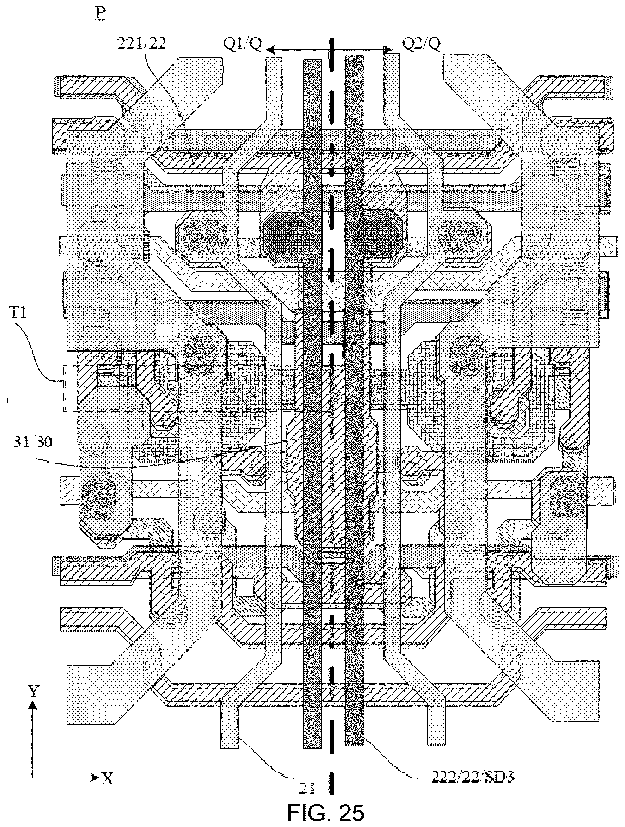

FIG. 25 is a structural diagram showing a film layer of a pixel driving unit, in accordance with yet some other embodiments.

In some embodiments, referring to FIG. 25, the driving circuit layer 20 may further include a third wiring metal layer SD3 other than the first semiconductor layer POLY1, the first gate metal layer Gate1, the second gate metal layer Gate2, the first wiring metal layer SD1 and the second wiring metal layer SD2 that are stacked on the base substrate 10. The third wiring metal layer SD3 is located on a side of the second wiring metal layer SD2 away from the first wiring metal layer SD1.

For example, the material of the third wiring metal layer SD3 may be a titanium (Ti)-aluminum (Al)-titanium (Ti) multi-layer composite material. Based on this, a square resistance of the third wiring metal layer SD3 is about 0.05 mΩ/□.

For example, the third wiring metal layer SD3 and the second wiring metal layer SD2 are provided with a third planarization layer therebetween. The third planarization layer is used to electrically insulate the third wiring metal layer SD3 and the second wiring metal layer SD2.

For example, a material of the third planarization layer is generally an organic material. For example, the material of the third planarization layer may include at least one of polyimide (PI), an acrylic-based polymer, or a silicon-based polymer.

In a case where the driving circuit layer 20 of the display panel 100 includes the third wiring metal layer SD3, the second lead segment 222 of the data lead 22 may be disposed in the third wiring metal layer SD3. Compared to arranging the second lead segment 222 in the second wiring metal layer SD2, it may be conducive to increasing the distance between the second lead segment 222 and the first electrode a1 of the driving transistor T1 by arranging the second lead segment 222 of the data lead 22 in the third wiring metal layer SD3, so that the influence of the data writing signal transmitted by the second lead segment 222 to the data writing signal line 21 on the potential of the first electrode a1 of the driving transistor T1 when the data writing signal jumps may be reduced, which is conducive to improving the stability of the driving transistor T1 in the pixel driving sub-circuit Q and improving the brightness uniformity of the display panel 100.

Based on the structure of the driving circuit layer 20 in the display panel 100, it can be known that the driving transistor T1 is mainly formed in the first semiconductor layer POLY1 and the first gate metal layer Gate1, and the second lead segment 222 of the data lead 22 is formed in the third metal wiring layer SD3. It can be known that the second lead segment 222 and the driving transistor T1 are provided with at least the second gate metal layer Gate2, the first wiring metal layer SD1 and the second wiring metal layer SD2 therebetween.

Furthermore, the first shielding pattern 31 may be disposed in at least one of the second gate metal layer Gate2, the first wiring metal layer SD1, and the second wiring metal layer SD2. The film layer position of the first shielding pattern 31 may include following situations.

In a first situation, the first shielding pattern 31 is disposed in the second gate metal layer Gate2.

In a second situation, the first shielding pattern 31 is disposed in the first wiring metal layer SD1.

In a third situation, the first shielding pattern 31 is disposed in the second wiring metal layer SD2.

In a fourth situation, the first shielding pattern 31 is disposed in the second gate metal layer Gate2 and the first wiring metal layer SD1.

In a fifth situation, the first shielding pattern 31 is disposed in the second gate metal layer Gate2 and the second wiring metal layer SD2.

In a sixth situation, the first shielding pattern 31 is disposed in the first wiring metal layer SD1 and the second wiring metal layer SD2.

In a seventh situation, the first shielding pattern 31 is disposed in the second gate metal layer Gate2, the first wiring metal layer SD1, and the second wiring metal layer SD2.

In a case where the first shielding patterns 31 are distributed in two or three layers, portions of the first shielding patterns 31 in different film layers may be electrically connected to each other.

Based on this, the first shielding pattern 31 may be disposed in the metal layers (the second gate metal layer Gate2, the first wiring metal layer SD1 and the second wiring metal layer SD2) sandwiched between the second lead segment 222 and the driving transistor T1 according to the layout space situation of the metal layers. The first shielding pattern 31 may be used to isolate the second lead segment 222 and the driving transistor T1, so as to ameliorate the problem of the potential jump of the driving transistor T1 caused by the second lead segment 222, thereby improving the brightness uniformity of the display panel 100. Furthermore, the space of the metal layers sandwiched between the second lead segment 222 and the driving transistor T1 may be fully utilized without separately providing a metal film layer to form the first shielding pattern 31, which is further beneficial to the lightness and thinness of the display panel 100.

In addition, the solution in the above embodiments that components in different film layers may further be used as the first shielding pattern 31 is also applicable to this embodiment, and details will not be repeated here.

It will be noted that, except for the second metal wiring layer SD2 in FIG. 25, the other film layer structure diagrams are the same as the film layer decomposition diagram of the pixel driving sub-circuit Q shown in FIG. 15, and the only difference for the second wiring metal layers SD2 is that the second lead segment 222 in the second wiring metal layer SD2 shown in FIG. 15 is moved to the third wiring metal layer SD3.

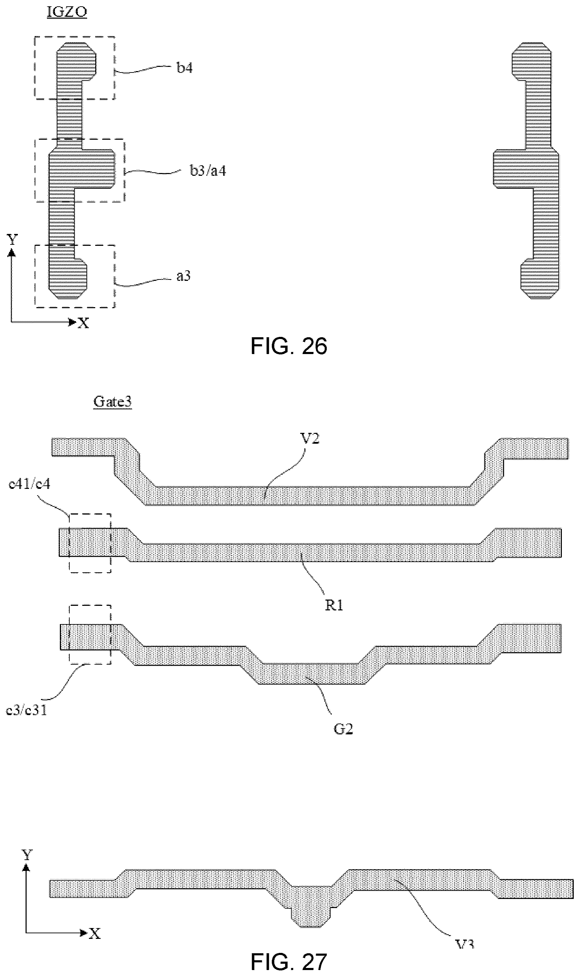

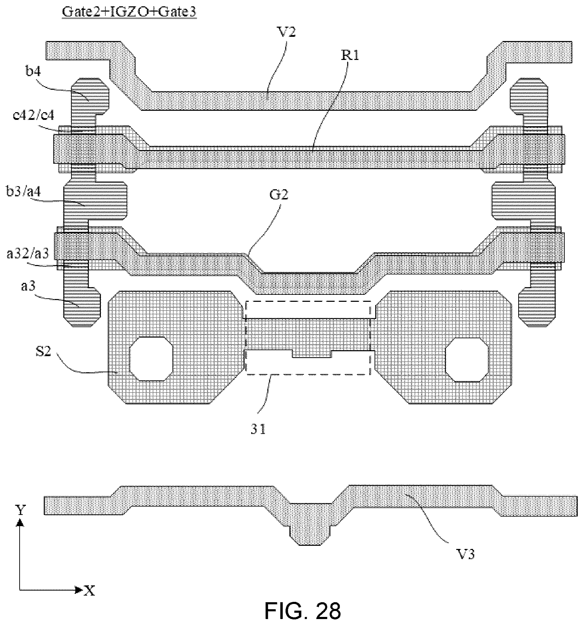

FIG. 26 is a diagram showing a film layer of the second semiconductor layer in FIG. 15; FIG. 27 is a diagram showing a film layer of the third gate metal layer in FIG. 15; and FIG. 28 is a diagram showing film layers of the second gate metal layer, the second semiconductor layer, and the third gate metal layer in FIG. 15.

In some embodiments, as shown in FIGS. 15, 17 to 22, and 26 to 28, the driving circuit layer 20 may further include a second semiconductor layer IGZO and a third gate metal layer Gate3. The compensation transistor T3 and the first reset transistor T4 in the pixel driving sub-circuit Q may be oxide thin film transistors. The gate c3 of the compensation transistor T3 includes a top gate c31 of the compensation transistor T3 and a bottom gate c32 of the compensation transistor T3, and the gate c4 of the first reset transistor T4 includes a top gate c41 of the first reset transistor T4 and a bottom gate c42 of the first reset transistor T4.

The bottom gate c32 of the compensation transistor T3 and the bottom gate c42 of the first reset transistor T4 are located in the second gate metal layer Gate2.

The second semiconductor layer IGZO is located on a side of the second gate metal layer Gate2 away from the first gate metal layer Gate1. The second semiconductor layer IGZO includes the first electrode a3 of the compensation transistor T3, the second electrode b3 of the compensation transistor T3, the first electrode a4 of the first reset transistor T4, and the second electrode b4 of the first reset transistor T4.

The third gate metal layer Gate3 is located on a side of the second semiconductor layer IGZO away from the second gate metal layer Gate2. The second gate metal layer Gate2 includes the first reset transistor T4 and the top gate c41 of the first reset transistor T4.

No matter the second lead segment 222 is located in the second wiring metal layer SD2 or the second lead segment 222 is located in the third wiring metal layer SD3, the third gate metal layer Gate3 is located between the film layer where the second lead segment 222 is located and the first semiconductor layer POLY1. Furthermore, the first shielding pattern 31 may be formed in the third gate metal layer Gate3 to isolate the second lead segment 222 and the driving transistor T1, thereby ameliorating the problem of the potential jump of the driving transistor T1 caused by the second lead segment 222 and improving the brightness uniformity of the display panel 100. Furthermore, the space of the metal layers sandwiched between the second lead segment 222 and the driving transistor T1 may be fully utilized without separately providing a metal film layer to form the first shielding pattern 31, which is further beneficial to the lightness and thinness of the display panel 100.

In addition, there may also be other portions of the first shielding pattern 31 formed in other film layers sandwiched between the second lead segment 222 and the driving transistor T1, which is not limited in the present disclosure.

In some embodiments, as shown in FIGS. 15, 21 and 27, since the first sub-pixel area, the second sub-pixel area and the third sub-pixel area respectively emit light of three primary colors, the luminous efficiency of the light-emitting units O (return to FIG. 7) in sub-pixel areas of different colors may be different, which may easily lead to uneven color display of the display panel 100.

Based on this, one pixel driving sub-circuit Q may be correspondingly provided with two second initialization signal lines V2, and the two second initialization signal lines V2 are respectively a first second initialization signal line V2 and a second second initialization signal line V2. A second initialization signal provided by the first second initialization signal line V2 is different from a second initialization signal provided by the second second initialization signal line V2.

Therefore, different second initialization signal lines V2 may be selected for electrical connection according to the luminous efficiency of the light-emitting units O in the sub-pixel areas of different colors. That is, the light-emitting units O electrically connected to the pixel driving sub-circuits Q in the sub-pixel areas of different colors may be electrically connected to different second initialization signal lines V2, so that the light-emitting units O may be reset by using different second initialization signals, so that the brightness of light emitted by the sub-pixel areas of different colors is substantially the same, thereby improving the display effect of the display panel 100.

In some examples, the first of the two second initialization signal lines V2 may be formed in the first wiring metal layer SD1, and the second of the two second initialization signal lines V2 may be formed in the third gate metal layer Gate3. However, the embodiments of the present disclosure is not limited thereto, and the second of the two second initialization signal lines V2 may also be formed in other film layers with setting positions.

The above embodiments are illustrated by taking an example in which the light-emitting unit O is electrically connected to the first second initialization signal line V2 located in the first wiring metal layer SD1.

In some of the above embodiments, the film layer structure of the pixel driving circuit of "8T1C" is introduced, mainly introducing that the shielding layer 30 shields the first electrode of the driving transistor T1. It can be understood that in some other embodiments, in a case where the orthogonal projection of the second lead segment 222 on the base substrate 10 overlaps with the orthogonal projection of the second electrode of the driving transistor T1 on the base substrate 10, the shielding layer 30 may further be moved accordingly between the second electrode of the driving transistor T1 and the second lead segment 222.

In addition, in a case where the second lead segment 222 is proximate to the gate of the driving transistor T1, the shielding layer 30 may also be disposed at a side of the gate of the driving transistor T1 proximate to the second lead segment 222. The present disclosure is not limited thereto.

The above are only specific embodiments of the present disclosure, but the scope of protection of the present disclosure is not limited thereto, and any person skilled in the art may conceive of variations or replacements within the technical scope of the present disclosure, which shall fall within the protection scope of the present disclosure. Therefore, the protection scope of the present disclosure should be determined by the protection scope of the claims.

## Claims

1. A display panel, comprising a display area, wherein the display area includes a middle area and two edge areas, and the middle area is located between the two edge areas along a first direction;
the display panel comprises a base substrate and a driving circuit layer located on a side of the base substrate, wherein
the driving circuit layer includes:
a plurality of pixel circuit units arranged in a plurality of rows and a plurality of columns in the display area, wherein a pixel circuit unit includes at least one pixel driving sub-circuit, and a pixel driving sub-circuit includes a driving transistor;
a plurality of data writing signal lines located in the display area, wherein the plurality of data writing signal lines are arranged along the first direction and extend along a second direction; the second direction intersects the first direction; and a data writing signal line is connected to a column of pixel driving sub-circuits;
a plurality of data leads, wherein a data lead includes a first lead segment and a second lead segment; an end of the first lead segment is electrically connected to one data writing signal line located in an edge area, and another end of the first lead segment is electrically connected to an end of the second lead segment; the first lead segment extends along the first direction, and the second lead segment extends along the second direction; the second lead segment is located in the middle area; and an orthogonal projection of the second lead segment on the base substrate at least partially overlaps with an orthogonal projection of a first electrode of at least one driving transistor on the base substrate; and
a shielding layer, wherein the shielding layer is configured to have a constant voltage signal; the shielding layer includes at least one first shielding pattern; a first shielding pattern is located between the first electrode of the driving transistor and the second lead segment; and an orthogonal projection of the first shielding pattern on the base substrate, the orthogonal projection of the first electrode of the driving transistor on the base substrate, and the orthogonal projection of the second lead segment on the base substrate overlap.

2. The display panel according to claim 1, wherein the orthogonal projection of the first shielding pattern on the base substrate covers the orthogonal projection of the first electrode of the driving transistor on the base substrate.

3. The display panel according to claim 1 or 2, wherein along the first direction, the second lead segment and the first shielding pattern are located on a same side of a gate of the driving transistor.

4. The display panel according to any one of claims 1 to 3, wherein the pixel driving sub-circuit further includes a data writing transistor and a first reset transistor;
a first electrode of the data writing transistor is electrically connected to one data writing signal line, and a second electrode of the data writing transistor is electrically connected to a first electrode of the driving transistor; and a first electrode of the first reset transistor is electrically connected to a gate of the driving transistor;
along the second direction, in the pixel driving sub-circuit in the pixel circuit unit, the first reset transistor is located on a side of the data writing transistor away from the driving transistor, and at least a portion of the first lead segment extending through the same pixel circuit unit is located on a side of the first reset transistor away from the data writing transistor.

5. The display panel according to claim 4, wherein along the first direction, the first lead segment includes a main body and an avoidance portion, and the avoidance portion protrudes relative to the main body toward a side away from the driving transistor; wherein the avoidance portion is located on the side of the first reset transistor away from the data writing transistor.

6. The display panel according to any one of claims 1 to 5, wherein the pixel circuit unit includes two pixel driving sub-circuits arranged along the first direction, and the two pixel driving sub-circuits are a first pixel driving sub-circuit and a second pixel driving sub-circuit, respectively;
a second lead segment corresponding to the first pixel driving sub-circuit is adjacent to a second lead segment corresponding to the second pixel driving sub-circuit; and
a first shielding pattern in the first pixel driving sub-circuit is arranged adjacent to a first shielding pattern in the second pixel driving sub-circuit.

7. The display panel according to claim 6, wherein the first shielding pattern in the first pixel driving sub-circuit is electrically connected to the first shielding pattern in the second pixel driving sub-circuit, and the first shielding pattern in the first pixel driving sub-circuit is arranged in a same layer as the first shielding pattern in the second pixel driving sub-circuit.

8. The display panel according to claim 6 or 7, wherein the first pixel driving sub-circuit and the second pixel driving sub-circuit are symmetrical along the first direction.

9. The display panel according to any one of claims 1 to 8, wherein an orthogonal projection of the first lead segment on the base substrate partially overlaps with an orthogonal projection of the data writing signal line on the base substrate; and
the shielding layer further includes at least one second shielding pattern, and a second shielding pattern is located between the first lead segment and the data writing signal line; and an orthogonal projection of the second shielding pattern on the base substrate, the orthogonal projection of the first lead segment on the base substrate, and the orthogonal projection of the data writing signal line on the base substrate overlap.

10. The display panel according to any one of claims 1 to 9, wherein the driving circuit layer further includes a first semiconductor layer, a first gate metal layer, a second gate metal layer, a first wiring metal layer, and a second wiring metal layer that are stacked on the base substrate;
a first electrode of the driving transistor is located in the first semiconductor layer; the first lead segment is located in the first wiring metal layer, and the second lead segment is located in the second wiring metal layer; and
the first shielding pattern is located in the second gate metal layer and/or the first wiring metal layer.

11. The display panel according to any one of claims 1 to 9, wherein the driving circuit layer further includes a first semiconductor layer, a first gate metal layer, a second gate metal layer, a first wiring metal layer, a second wiring metal layer, and a third wiring metal layer that are stacked on the base substrate;
a first electrode of the driving transistor is located in the first semiconductor layer, the first lead segment is located in the first wiring metal layer, and the second lead segment is located in the third wiring metal layer; and
the first shielding pattern is located in at least one of the second gate metal layer, the first wiring metal layer, and the second wiring metal layer.

12. The display panel according to claim 10 or 11, wherein the driving circuit layer further includes a third gate metal layer located between the second gate metal layer and the first wiring metal layer; and
at least a portion of the first shielding pattern is located in the third gate metal layer.

13. The display panel according to any one of claims 10 to 12, wherein the pixel circuit unit further includes a first power signal line located in the second wiring metal layer, and the first power signal line is configured to provide a constant voltage power signal to the pixel driving circuit; wherein the first power signal line is electrically connected to the shielding layer.

14. The display panel according to claim 12, wherein the pixel driving sub-circuit further includes a storage capacitor; a first electrode plate of the storage capacitor is electrically connected to a gate of the driving transistor, and a second electrode plate of the storage capacitor is electrically connected to the first power signal line; and
the first electrode plate of the storage capacitor is located in the first gate metal layer, and the first electrode plate of the storage capacitor is further used as the gate of the driving transistor; and the second electrode plate of the storage capacitor is located in the second gate metal layer.

15. The display panel according to claim 14, wherein the second electrode plate of the storage capacitor includes a first sub-portion; along a direction perpendicular to the base substrate, the first sub-portion, the first electrode of the driving transistor and the second lead segment overlap, and the first sub-portion is further used as the first shielding pattern.

16. The display panel according to claim 14 or 15, wherein the first wiring metal layer further includes a first connecting portion, the first connecting portion is used to electrically connect the second electrode of the storage capacitor and the first power signal line, and the first connecting portion is further used as the first shielding pattern.

17. The display panel according to any one of claims 14 to 16, wherein the pixel driving sub-circuit further includes a first light-emitting control transistor; a first electrode of the first light-emitting control transistor is electrically connected to the first electrode of the driving transistor, and a second electrode of the first light-emitting control transistor is electrically connected to the first power signal line; and
the first wiring metal layer further includes a first transfer portion; the first transfer portion is used to electrically connect the second electrode of the first light-emitting control transistor and the first power signal line, and the first transfer portion is further used as the first shielding pattern.

18. The display panel according to any one of claims 1 to 17, further comprising a bonding area, wherein the bonding area is located on a side of the display area; the bonding area includes a connecting lead, and another end of the data lead is electrically connected to the connecting lead.

19. A display device, comprising the display panel according to any one of claims 1 to 18.
